# EUROPEAN PATENT APPLICATION

(11) **EP 2 620 827 A2**
(43) Date of publication of application: **31.07.2013**
(21) Application number: 12193952.4
(22) Date of filing: 23.11.2012
(51) Int. Cl.: G05B 19/418

(54) **Work content creation apparatus and method, and workflow creation apparatus and method**

(30) Priority: 24.01.2012 JP 2012012455
(71) Applicant: FUJITSU LIMITED, Kawasaki-shi, Kanagawa 211-8588 (JP)
(72) Inventor: Akahoshi, Ryusuke, Kawasaka-shi, Kanagawa 211-8588 (JP); Tenma, Tsukasa, Kawasaki-shi, Kanagawa 211-8588 (JP); Morimoto, Mari, Kawasaki-shi, Kanagawa 211-8588 (JP); Furomoto, Yukihiko, Kawasaki-shi, Kanagawa 211-8588 (JP)
(74) Representative: Stebbing, Timothy Charles

(57) **Abstract**

A work content creation apparatus that carries out: deriving a motion range for a component that moves from animation data representing movement in 3-dimensional space of a component with a component name for work subject to processing, and based on a motion pattern and a motion condition stored in a first storage section, deriving a motion condition relationship to motion pattern of the component in the motion range; based on a correspondence relationship stored in a second storage section, deriving a work name corresponding to the motion condition relationship to motion pattern; and based on a correspondence relationship stored in a third storage section, deriving work content corresponding to the work name and the component name as work content of work performed on the component.

## Description

### FIELD

The embodiments discussed herein are related to a work content creation apparatus, a workflow creation apparatus, a work content creation method, and a workflow creation method.

### BACKGROUND

When products with single components or component groups containing plural components are manufactured, work content and work sequence are defined for each component of the single components or component groups. For example, work content and work sequence are defined for each component of the single components or component groups when executing tasks such as manufacturing line research. The man-hours for work can accordingly be derived from the work content and work sequence of the work, allowing evaluation to be performed of such factors as the man-hours for work in a manufacturing line.

As an example of a method for setting work content and work sequence, technology is known wherein work content and work sequences are set manually. However, setting work content and work sequences manually relies on the skill of an individual to understand the work content and work sequence needed for a product assembly operation. Variation in individual skill invites for example oversights in setting work content and work sequences, and there is variation in the work content and work sequences set. Variation in individual skill also creates large variations in the time needed to understand the work content and work sequence that have been set.

However, technology is known for automatically extracting features such as work content in place of manually setting work content and work sequences. For example, technology is known for automatically extracting features such as work content from setting data including component attribute data contained in CAD data representing component configurations in a product, and work content that has been carried out in the past. However, there is a possibility of under-extraction or over-extraction when for example work content is automatically extracted using attribute data relating to product components and past setting data. This is due for example to employing automatic setting patterns mimicking previously automatically extracted work content. There is accordingly a need to manually verify work content and work sequences that have been extracted automatically.

Technology is also known for assisting with work standards generation and man-hour setting for checking work on a manufacturing line. For example, technology is known wherein work man-hours are set by analyzing an operator's movements based on an animation representing the movements of components, and determining work units for a series of operations. In the generation of work standards, work elements corresponding to work content are stored in a system as a standards library, and a user selects work elements from the standards library and inputs them into the system. However, since an operator uses their own judgment in selecting and inputting work elements registered in the standards library this results in a reliance on individual skill. Variation can accordingly occur in work content, for example.

Technology is also known for creating a manufacturing flow expressing an assembly sequence of products including plural components. For example, technology is known wherein a manufacturing flow for products with customized configurations with differing component configurations is created from a manufacturing flow of a product with a base component configuration. When a manufacturing flow is created for a product with a customized configuration, whether or not customized configuration components can be mounted is determined with an assembly animation, and an overall manufacturing flow is created by organizing flow in the component work sequence. However, in order to create a customized configuration manufacturing flow input still has to be made to a pre-prepared base configuration manufacturing flow. There is therefore still a reliance on individual skill when pre-preparing a manufacturing flow using a base configuration. Consequently, variation in work content can occur.

### [Related Patent Documents]

Japanese Laid-Open Patent Publication No. 2002-207511
Japanese Laid-Open Patent Publication No. 2004-326370

Work content setting of that relies on individual skill has a detrimental impact on manufacturing line evaluation. Namely, when plural operators evaluate the same manufacturing line, variation in the evaluation results can occur depending on the operator that performed the evaluation. There is accordingly a demand in manufacturing line evaluation to eliminate work that relies on individual skill, and manufacturing line research is being performed into the time-consuming work for combining and comparing evaluation results from certain experts or many people.

### SUMMARY

Accordingly, it is an object in one aspect of the embodiment to determine work content without relying on experience or skill.

According to an aspect of the embodiments, a work content creation apparatus includes: a processor; and a memory storing instructions, which when executed by the processor perform a first procedure, the first procedure including: (a) storing, in a first storage section of the memory, a motion pattern expressing a category of motion of a component and a motion condition expressing a condition to classify motion of the component; (b) storing, in a second storage section of the memory, a correspondence relationship between a work name expressing a name of work performed on the component and the motion condition relationship to motion pattern of the component; (c) storing, in a third storage section of the memory, a correspondence relationship between the work name, a component name that is a term for the component, and work content expressing content of work performed on the component; (d) deriving a motion range for a component that moves from animation data representing movement in 3-dimensional space of a component with a component name for work subject to processing, and based on the motion pattern and the motion condition stored in the first storage section, deriving the motion condition relationship to motion pattern of the component in the motion range; (e) based on the correspondence relationship stored in the second storage section, deriving a work name corresponding to the motion condition relationship to motion pattern derived at (d); and (f) based on the correspondence relationship stored in the third storage section, deriving work content corresponding to the work name derived at (e) and the component name as work content of work performed on the component.

### BRIEF DESCRIPTION OF DRAWINGS

Fig. 1 is a block diagram illustrating an outline configuration of a workflow creation apparatus according to an exemplary embodiment;
Fig. 2 is a schematic block diagram of a computer functioning as a flow creation apparatus;
Fig. 3 is an illustration of an example of a motion pattern database;
Fig. 4 is an illustration of an example of a motion condition database;
Fig. 5 is an illustration of an example of a work-motion database;
Fig. 6 is an illustration of an example of a work-component database;
Fig. 7 is an illustration of an example of a work-work keyword database;
Fig. 8 is an illustration of an example of a work content database;
Fig. 9A is an illustration of animation data;
Fig. 9B is an illustration of a workflow;
Fig. 9C is an illustration with added work content;
Fig. 10 is an illustration of animation data;
Fig. 11 is a flowchart illustrating an example of a workflow creation processing flow;
Fig. 12 is a flowchart illustrating an example of a workflow creation processing flow;
Fig. 13 is a flowchart illustrating an example of a workflow creation processing flow;
Fig. 14 is a flowchart illustrating an example of a workflow creation processing flow;
Fig. 15 is a flowchart illustrating an example of a workflow creation processing flow;
Fig. 16 is a flowchart illustrating an example of a workflow creation processing flow;
Fig. 17A is an illustration of workflow data output results;
Fig. 17B is an illustration of workflow data output results;
Fig. 18 is an illustration of animation data;
Fig. 19A is an illustration of workflow data output results; and
Fig. 19B is an illustration of workflow data output results.

### DESCRIPTION OF EMBODIMENTS

Detailed explanation follows regarding an example of exemplary embodiments of technology disclosed herein, with reference to the drawings.

### First Exemplary Embodiment

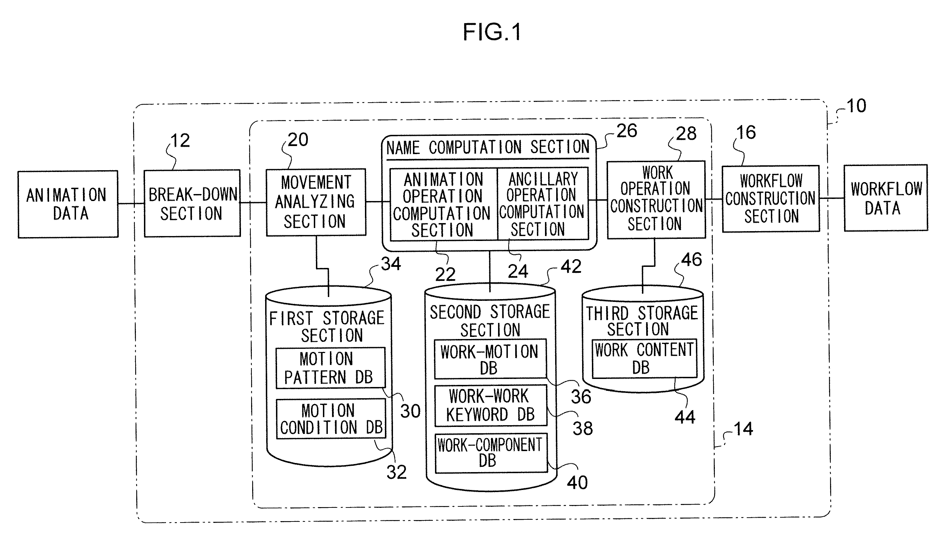

Fig. 1 illustrates a workflow creation apparatus 10 according to a first exemplary embodiment. The workflow creation apparatus 10 preforms processing to create work content and workflow for components included in a section of an object from animation data representing movements of the object in 3-dimensional space. The workflow creation apparatus 10 includes a break-down section 12, a work content creation apparatus 14 and a workflow construction section 16. The work content creation apparatus 14 includes a motion analysis section 20, a name computation section 26, and a work operation construction section 28. The work content creation apparatus 14 also includes a motion pattern database (database is abbreviated in the following to DB) 30, and a first storage section 34 for storing a motion condition DB 32. The work content creation apparatus 14 also includes a second storage section 42 stored with a work-motion DB 36, a work-work keyword DB 38 and a work-component DB 40, and a third storage section 46 stored with a work content DB 44. The name computation section 26 includes an animation operation computation section 22 and an ancillary operation computation section 24.

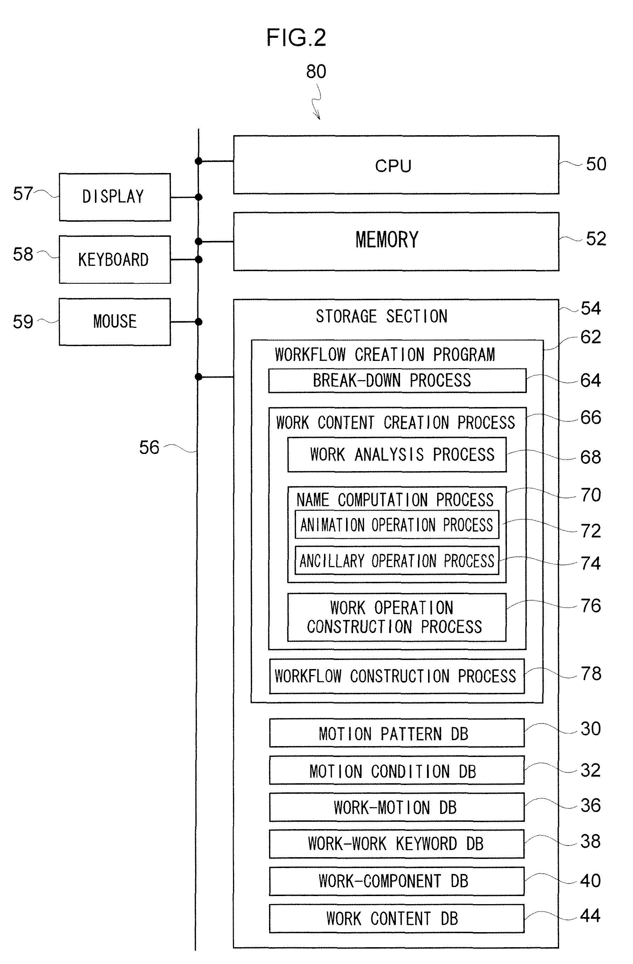

The workflow creation apparatus 10 can for example be implemented by a computer 80 as illustrated in Fig. 2. The computer 80 includes a CPU 50, a memory 52, a nonvolatile storage section 54, a keyboard 58, a mouse 59 and a display 57, with these connected together through a bus 56. Note that the storage section 54 can be implemented by a Hard Disk Drive (HDD) or flash memory. A workflow creation program 62 is stored in the storage section 54, serving as a storage medium, for causing the computer 80 to function as the workflow creation apparatus 10. Each of the motion pattern DB 30, the motion condition DB 32, the work-motion DB 36, the work-work keyword DB 38, the work-component DB 40 and the work content DB 44 are stored in the storage section 54. The CPU 50 reads the workflow creation program 62 from the storage section 54, expands the workflow creation program 62 in the memory 52, and executes the processes of the workflow creation program 62 in sequence.

The workflow creation program 62 includes a break-down process 64, a work content creation process 66, and a workflow construction process 78. The CPU 50 operates as the break-down section 12 illustrated in Fig. 1 by executing the break-down process 64. The workflow creation apparatus 10 is implemented by computer 80, and the computer 80 operates as the break-down section 12 (Fig. 1) by executing the break-down process 64. In such cases, a part region of the memory 52 is employed as a region for storing part animation data derived by the processing of the break-down section 12. The CPU 50 also operates as the work content creation apparatus 14 illustrated in Fig. 1 by executing the work content creation process 66. The CPU 50 operates as the workflow construction section 16 illustrated in Fig 1 by executing the workflow construction process 78. The workflow creation apparatus 10 is implemented by the computer 80, and the computer 80 operates as the workflow construction section 16 (Fig. 1) by executing the workflow construction process 78. In such cases, a part region of the memory 52 is employed as a region for storing workflow data derived by processing of the workflow construction section 16. The computer 80 that executed the workflow creation program 62 thereby functions as the workflow creation apparatus 10.

The workflow creation program 62 is an example of the workflow creation program of technology disclosed herein, and the work content creation process 66 contained in the workflow creation program 62 is an example of the work content creation program of technology disclosed herein. Namely, the work content creation process 66 is an example of the work content creation program for causing the computer 80 to function as the work content creation apparatus 14.

The work content creation program (the work content creation process 66) includes a work analysis process 68, a name computation process 70 and a work operation construction process 76. The CPU 50 operates as the motion analysis section 20 illustrated in Fig. 1 by executing the work analysis process 68. The CPU 50 operates as the name computation section 26 illustrated in Fig. 1 by executing the name computation process 70. The CPU 50 operates as the work operation construction section 28 illustrated in Fig. 1 by executing the work operation construction process 76. Note that an animation operation process 72 and an ancillary operation process 74 are contained in the name computation process 70. The CPU 50 operates as the animation operation computation section 22 illustrated in Fig. 1 by executing the animation operation process 72 and operates as the ancillary operation computation section 24 illustrated in Fig. 1 by executing the ancillary operation process 74.

When the workflow creation apparatus 10 is implemented by the computer 80, the storage section 54 is employed as the first storage section 34 for storing the motion pattern DB 30 and the motion condition DB 32. A part region of the memory 52 is employed as a region for storing motion patterns derived by the processing of the motion analysis section 20. The storage section 54 is employed as the second storage section 42 for storing the work-motion DB 36, the work-work keyword DB 38 and the work-component DB 40. A part region of the memory 52 is employed as a region to store work names and work name candidates derived by the processing of the name computation section 26. The storage section 54 that stores the work content DB 44 is employed as the third storage section 46. A part region of the memory 52 is employed as a storage region for storing work content derived by the processing of the work operation construction section 28. The computer 80 executing the work content creation program thereby functions as the work content creation apparatus 14.

The break-down section 12 of the workflow creation apparatus 10 performs, in the following manner, part animation break-down on components included in a section of a product from animation data representing movement of the input product in 3-dimensional space. Motion record data, expressing for example a time series for assembly of a product, is input as animation data to the workflow creation apparatus 10. The break-down section 12 breaks down the animation data of components in motion into units of, for example, a single component, or a component group including plural components, contained in a product. The animation data is thereby broken down into plural part motion record data (plural part animation data) with units of the break-down components or component groups.

An example of animation data is data recording movements of an object in virtual space constructed for example by 3D CAD and digital mockups, recorded by moving and rotating a graphic representing the object placed in the virtual space. In the present exemplary embodiment explanation follows regarding an example in which animation data has been created for instruction of work such as assembly and disassembly of a product. An object that is moving, namely an object in motion, can be represented by components of a product, and motion data, component attributes and explanatory information can be included.

The motion data is data for moving a component (or a component group configured by plural component, such as an assembly) in virtual 3D space. For example, examples of motion data include data related for example to the position of a moving component, data of the placement coordinates when component assembly is complete, data representing a name or drawing number of a moving component, and explanatory information such as assembly work instructions. Data in the motion data relating to the position of moving component includes coordinates from a move start point to a move end point. For example, the start coordinates and the end coordinates of a movement. Note that even though movement of a component appears to stop when explanatory information appears or when stopped mid-movement, it can be treated as continuous movement unless there is motion other than for the component. Motion data is also data relating to the movement of components or component groups. Namely, the motion data may include data of a moving component or component group and data representing motion content. Component attributes are data associated with components. For example data expressing the name of a component and data expressing a drawing number. Component attributes may also include data relating to the surface area, weight, material, density, and shape such as maximal external shape of a component. Explanatory information is data to assist work. For example, data expressing tab fitting locations, data expressing air-blow cleaning. The explanatory information may also include text of an explanation displayed during movement or when movement is halted, and data representing the timing for display. Note that the motion data may employ common data for component attribute of components and explanatory information. For example, the data representing the name and the drawing number of a moving component is sometimes common to data associated with a component as a component attribute. In the motion data, explanations such as assembly work instructions are sometimes common to data assisting work as explanatory information.

In the present exemplary embodiment, motion is motion of a component or component group moving from a motion start to a motion end. In the present exemplary embodiment, a motion range is from motion start to motion end, taken as a single unit. Note that there are also instances when even when a component or component group is positioned at the same position this is still treated as a single motion. Motion start is taken as the time a newly displayed component, or a component being displayed starts moving. Motion end is taken as when a first component of the motion start is positioned just prior to a second component different from the first component starting to move, or taken as when motion of the first component is at the final motion complete position after movement has been completed. In the present exemplary embodiment, motion patterns represent categories of motion. Examples of motion patterns correspond to content in which the motion start position is the same as the initial position of a component, or the motion end position is the same as the initial position of a component.

In the present exemplary embodiment, component name is a general term used to name a component and is associated with the name for a component (for example for a small screw, tapping screw etc. the name is: screw). Work name is a term that expresses work (for example attaching, adhering). Work content is a term expressing the content of work including name and work name (adhere protective sheet, attach front cover etc.). In other words, work content is an entity that enables the man-hours to be uniquely determined for work arising from the work content. In the present exemplary embodiment, an entity defined by the work content and such factors as the component attributes, man-hours etc. is called an operation. A work operation is the work content representing work for a component and data including appended data such as man-hours. However, although work operation contains work content, it does not matter whether or not appended data are contained.

The work content creation apparatus 14 employs part animation data that is animation data that has been broken down by the break-down section 12 of the workflow creation apparatus 10 to create work content of a component as described below. The work content creation apparatus 14 functions as an example of a work content creation section of the technology disclosed herein. Detailed content of the processing of the work content creation apparatus 14 is described later. Based on the results of work content for a component created by the work content creation apparatus 14, the workflow construction section 16 creates workflow data organized in work sequence of the work content. The workflow construction section 16 functions as an example of a workflow construction section of technology disclosed herein.

The motion analysis section 20 of the work content creation apparatus 14 employs part animation data that has been broken down by the break-down section 12 and performs motion analysis as set out below. Namely, from the animation data, for motion of the component or component group in 3-dimensional space, the motion analysis section 20 uses the content of the motion patterns registered in the motion pattern DB 30 to derive a motion pattern that matches a motion condition registered in the motion condition DB 32. The motion analysis section 20 functions as an example of a motion analysis section of technology disclosed herein.

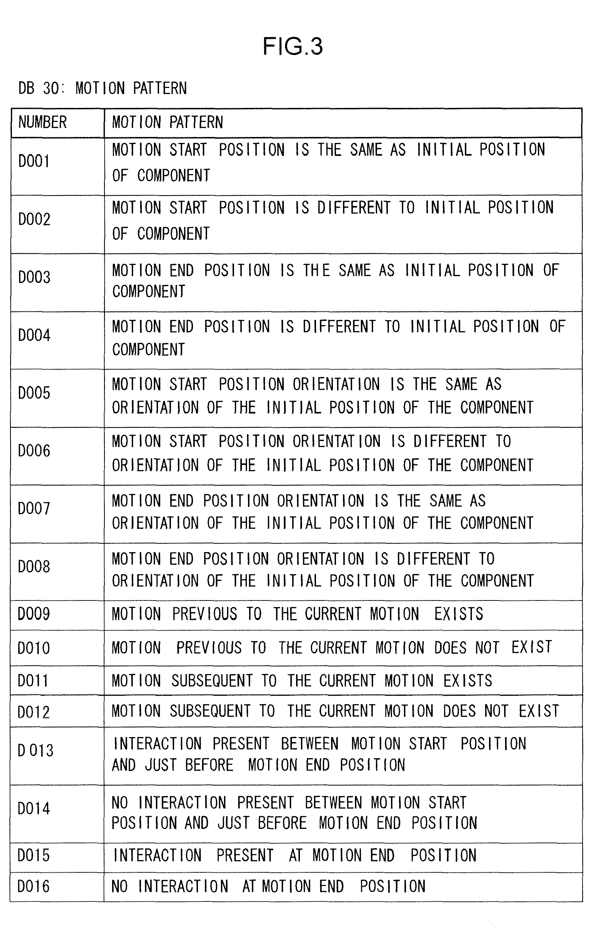

The motion pattern DB 30, as illustrated in the example of Fig. 3, is registered with the respective data for "number" and "motion pattern" associated with each other. The data for "motion pattern" illustrated in Fig. 3 is data representing content of motion patterns, and data for "number" is data for identifying content of motion patterns. For example, in Fig. 3 numbers in a continuous number series with the label "D" correspond to the data for "number", and data representing the content of motion patterns correspond to the data for "motion pattern". In the examples of correspondence relationships in the motion pattern DB 30 of Fig. 3, the motion pattern "motion start position same as initial position of component" is set against number "D001". Note that only some motion patterns are illustrated in Fig. 3, and there is no limitation to the correspondence relationships of the motion pattern DB 30 illustrated in Fig. 3.

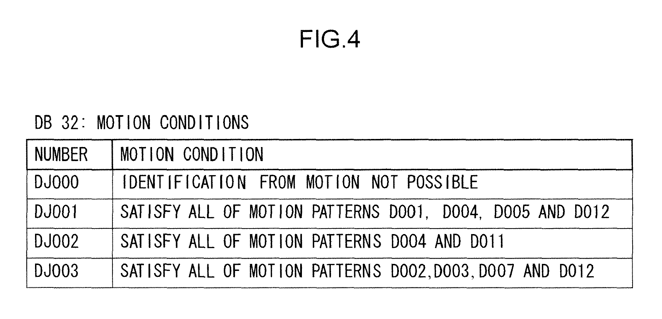

In the motion condition DB 32, respective data for "number" and "motion condition" are associated with each other and registered as illustrated in the example of Fig. 4. The data for "motion condition" illustrated in Fig. 4 is data representing the content of motion condition, and the data of "number" is data for identifying the content of motion conditions. For example, in Fig. 4, numbers in a continuous number series with the label "DJ" correspond to the data for "number", and data representing the content of motion condition correspond to the data for "motion pattern". In the example of correspondence relationships in the motion condition DB 32 illustrated in Fig. 4, motion condition "satisfies all of motion patterns D001, D004, D005 and D012" is set against the number "DJ001". Note that only some motion conditions are illustrated in Fig. 4, and there is no limitation to the correspondence relationships of the motion condition DB 32 illustrated in Fig. 4.

Note that in the present exemplary embodiment, explanation is of an embodiment in which the motion pattern DB 30 and the motion condition DB 32 are pre-stored in the first storage section 34. However, configuration may be made such that the motion pattern DB 30 and the motion condition DB 32 are, for example, received by communication with an external data processing apparatus and stored in the memory 52. The motion pattern DB 30 and the motion condition DB 32 are also not limited to being entirely stored in the first storage section 34 or the memory 52. For example, the motion pattern DB 30 and the motion condition DB 32 may be stored in a storage section stored with individual independent databases, and may be stored distributed across a computer network such as the Internet.

The name computation section 26 of the work content creation apparatus 14 extracts and specifies a work name from the work-motion DB 36 in which work names are registered associated with the work patterns that are the analysis results of the motion analysis section 20. The name computation section 26 functions as an example of the name computation section of technology disclosed herein. The name computation section 26 uses the animation operation computation section 22 to extract candidate work name(s) and uses the ancillary operation computation section 24 to extract candidate work name(s), and is able to specify a work name from the extracted candidate work name(s). Namely, the animation operation computation section 22 of the name computation section 26 extracts from the work-motion DB 36 as first work name candidates any work names registered in the work-motion DB 36 corresponding to the motion pattern that is the analysis result of the motion analysis section 20. The name computation section 26 then extracts from the work-component DB 40 or the work-work keyword DB 38, as second work name candidates, any work names corresponding to the component name of relevant components contained in the part animation data and registered in the work-component DB 40. The ancillary operation computation section 24 of the name computation section 26 also extracts from the work-component DB 40 and the work-work keyword DB 38, as second work name candidates, any work names corresponding to explanatory information matching text registered in the work-work keyword DB 38. The name computation section 26 then identifies work names based on the first work name candidates and the second work name candidates. The animation operation computation section 22 functions as an example of an animation operation computation section in the technology disclosed herein. The ancillary operation computation section 24 functions as an example of an ancillary operation computation section of technology disclosed herein.

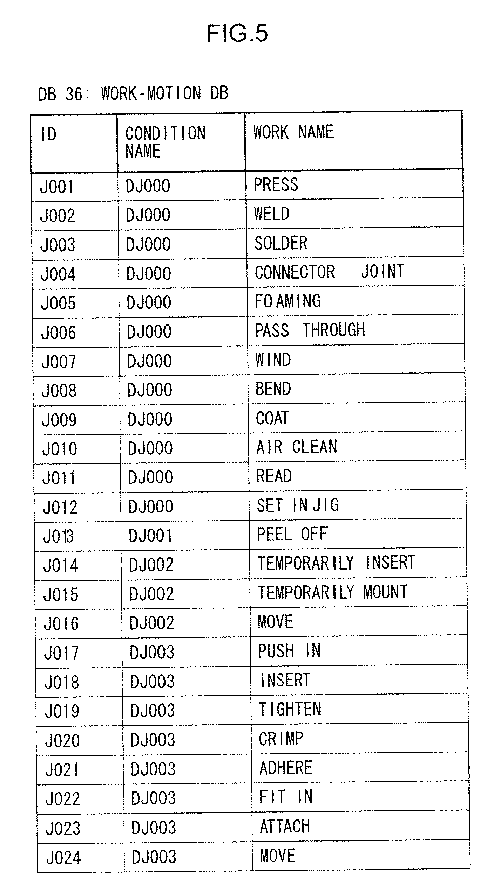

As illustrated in the example of Fig. 5, respective data for "ID", "condition name" and "work name" are registered associated with each other in the work-motion DB 36. The data for "condition name" illustrated in Fig. 5 is data representing motion patterns matching motion conditions, the data for "work name" is data representing the name of work. The data "ID" is data for identifying correspondence relationships between "condition name" and "work name". For example, in Fig. 5 numbers in a continuous number series with the label "J" correspond to the data for "ID". Data for "condition name" is data representing the name of work corresponding to data of "condition name" and is stored as data of "work name" that is also stored as data of "number" in the motion condition DB 32. In the example of correspondence relationships in the work-motion DB 36 illustrated in Fig. 5, the condition name "DJ000" and the work name "press" are set as for the ID "J001". Note that Fig. 5 only illustrates some correspondence relationships between condition name and work name, and there is no limitation to the correspondence relationships of the work-motion DB 36 illustrated in Fig. 5.

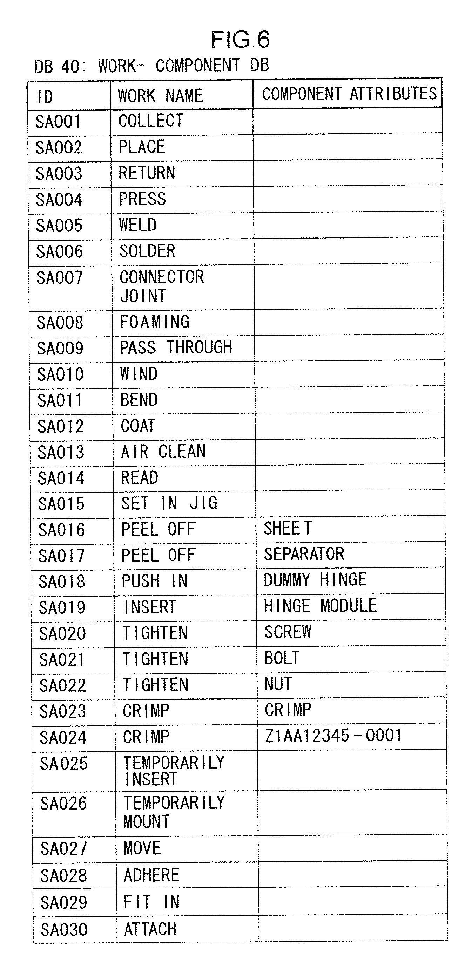

As illustrated in the example of Fig. 6, respective data for "ID", "work name" and "component attribute" are registered associated with each other in the work-component DB 40. The data of "work name" illustrated in Fig. 6 is data expressing the name of work, the data of "component attribute" is for example data expressing component names and data expressing drawing numbers associated with the component being moved. The data of "ID" is data for identifying correspondence relationships between "work name" and "component attribute". For example in Fig. 6 numbers in a continuous number series with the label "SA" correspond to the data for "ID". Data for "work name" is stored with data representing the name of work, and data for "component attribute" is stored with data representing a component attribute of a unique component corresponding to the work name. In the example of correspondence relationships in the work-component DB 40 of Fig. 6, for the ID "SA001" the work name "collect" and the component attribute "" (blank) are set. Note that only some correspondence relationships between work name and component attribute are illustrated in Fig. 6, and there is no limitation to the correspondence relationships of the work-component DB 40 illustrated in Fig. 6.

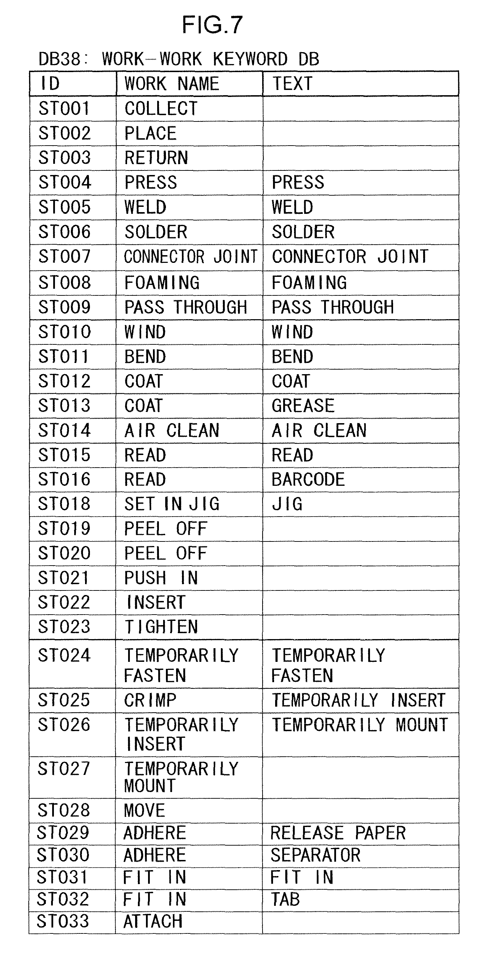

As illustrated in the example of Fig. 7, respective data for "ID", "work name" and "text" are stored associated with each other in the work-work keyword DB 38. The data for "work name" illustrated in Fig. 7 is data expressing names of work, the data of "text" is data expressing a keyword that is part of data to assist work contained in for example explanatory information. The data of "ID" is data for identifying the correspondence relationships between "work name" and "text". For example, numbers in a continuous number series with the label "ST" correspond to the data for "ID" in Fig. 7. The data of "work name" is stored as data representing names of work, the data of "text" is stored as data to assist work corresponding to the work name. In the example of correspondence relationships in the work-work keyword DB 38 illustrated in Fig. 7, the work name "collect" and the text "" (blank) is set for the ID "ST001". Note that only some correspondence relationships between work name and text are illustrated in Fig. 7, and there is no limitation to the correspondence relationships of the work-work keyword DB 38 illustrated in Fig. 7.

Note that in the present exemplary embodiment an example is given of an embodiment in which the work-motion DB 36, the work-component DB 40 and the work-work keyword DB 38 are pre-stored in the second storage section 42. However, configuration may be made with the work-motion DB 36, the work-component DB 40 and the work-work keyword DB 38 received, for example, by communication with an external data processing apparatus and stored on the memory 52. The work-motion DB 36, the work-component DB 40 and the work-work keyword DB 38 are also not limited to being entirely stored on either the second storage section 42 or the memory 52. For example, the work-motion DB 36, the work-component DB 40 and the work-work keyword DB 38 may be stored in a storage section with individual independent databases, or may be stored distributed across a computer network such as the Internet.

The work operation construction section 28 of the work content creation apparatus 14 employs data representing the work name determined by the name computation section 26 and performs work operation construction. Namely, the work operation construction section 28 derives data representing work content for the motion in virtual 3D space of a component or component group from data representing work name and component name, from the work content registered in the work content DB 44. The work operation construction section 28 functions as an example of a work operation construction section of technology disclosed herein.

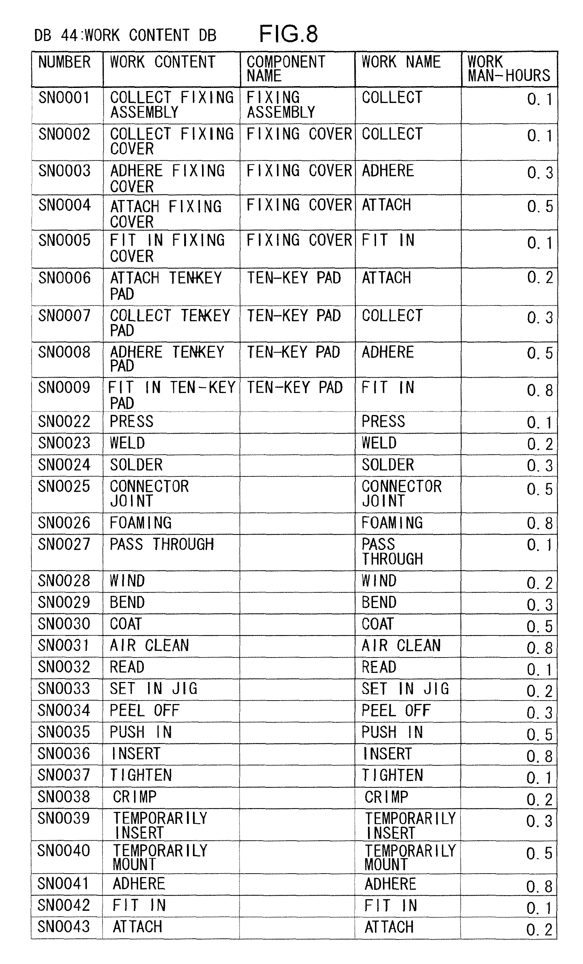

As illustrated in the example of Fig. 8, respective data for "number", "work content", "component name", "work name" and "work man-hours" are registered associated with each other in the work content DB 44. The data of "work content" illustrated in Fig. 8 is data expressing the content of work, the data "component name" is data expressing names of components, the data for "work name" is data expressing names of work. The data "number" is data for identifying correspondence relationships between "work content", "component name" and "work name". The data of "work man-hours" is data representing the man-hours for the work set by "work content", "component name" and "work name". The work man-hours are stored with pre-derived periods of time. For example, in Fig. 8 numbers in a continuous number series with the label "SN" correspond to the data for "number". In the example of correspondence relationships in the work content DB 44 illustrated in Fig. 8, data for work content "collect fixing assembly", component name "fixing assembly", work name "collect" and work man-hours "0.1" are set for number "SN0001". Note that Fig. 8 only illustrates some correspondence relationships of work content, component name and work name, and there is no limitation to the correspondence relationships of the work content DB 44 illustrated in Fig. 8. The work content DB 44 of the present exemplary embodiment is not limited to containing "work man-hours" in the work content DB 44. Namely, the work content DB 44 may omit the item "work man-hours".

Note that although explanation has been given in the present exemplary embodiment of an embodiment in which the work content DB 44 is pre-stored in the third storage section 46, configuration may be made such that the work content DB 44 is, for example, received by communication with an external data processing apparatus and stored on the memory 52. The work content DB 44 is also not limited to being stored on the third storage section 46 or the memory 52. Configuration may be made such that for example the work content DB 44 is stored in external storage section(s) disposed on a computer network such as the Internet.

Explanation follows regarding operation of the present exemplary embodiment. For example, generally in manufacturing line research, work content including a workflow is set first, then evaluation parameters such as man-hours are appended to the work content, and evaluation is performed on such factors as man-hours. However, when the work content to which evaluation parameters are appended is determined by the decision of an operator themselves, then results differ according to the experience and inherent skill of the operator. In the present exemplary embodiment, as a first aspect a process is provided for manufacturing line evaluation in which the work content that relies on the experience and skill of an operator is determined automatically, such that anyone who performs the evaluation obtains the same result in a short time. However, for automatically creating a workflow in which work content is arranged in work sequence from animation data expressing work for assembling or disassembling components, the precision needs to be raised for determining the work involved in processes for assembling or disassembling components in order to secure precision in the workflow. In order to determine the work involved in the processes for assembling or disassembling components, the precision needs to be raised for work content creation to create work content for a component or component group configuring part of a product contained in animation data. However, work for a component or component group is often dependent on motion of components for example, rather than the relationship between components, and so preferably work content is determined based on motion of components.

In consideration of the above, the present exemplary embodiment is provided with the motion pattern DB 30, the motion condition DB 32, the work-motion DB 36, the work-component DB 40, the work-work keyword DB 38 and the work content DB 44. As explained in the following, the present exemplary embodiment refers to databases according to the situation, and automatically creates a workflow in which work content from animation data is arranged in work sequence. However, in the present exemplary embodiment, in order to at least determine work content from animation data, the animation data is accordingly configured to include motion data as data for moving a component in 3-dimensional space. Animation data preferably includes component attributes as data associated with components to be moved and explanatory information as data to assist work.

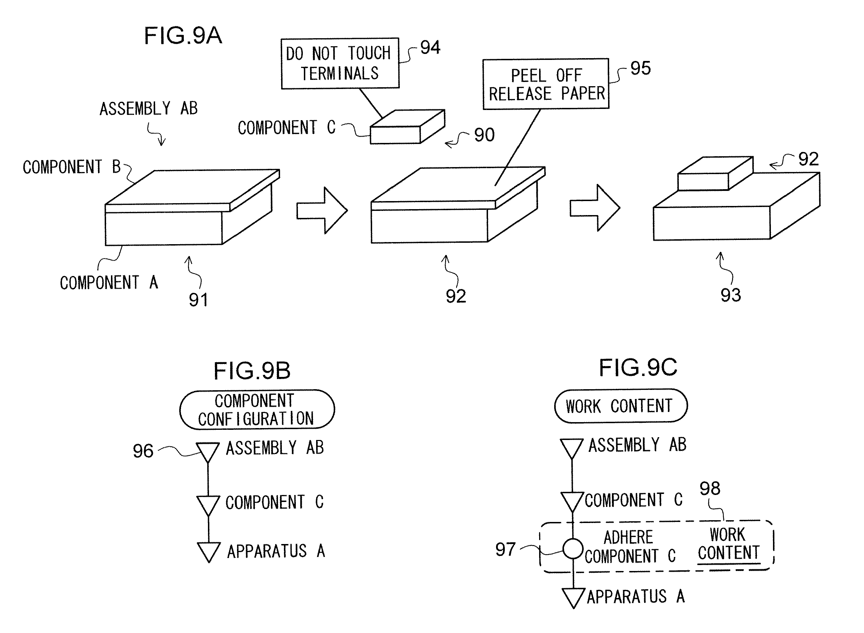

Outline explanation first follows regarding workflow creation processing executed by the workflow creation apparatus 10 including the work content creation apparatus 14, as illustrated in Fig. 9A to Fig. 9C. Fig. 9A is an illustration of animation data, Fig. 9B is an illustration of a workflow extracted with only component configuration from animation data, and Fig. 9C is an illustration in which work content extracted from animation data has been appended to a workflow.

The animation data illustrated in Fig 9A represents, as work related to component assembly, work up to adhering a component C to an assembly AB equipped with component A and component B. Namely, Fig. 9A illustrates a process from a state 91 in which assembly AB is prepared, through a state 92 in which C is prepared, to state 93 in which apparatus A has been completed. Note that at state 92 "do not touch terminals" is associated as explanatory information related to component C, and "peel off release paper" is associated as explanatory information related to the assembly AB. Note that the example of Fig. 9A to 9C illustrates a case in which only the component C is a component subject to work, and expresses part animation data related to the component C that moves. The break-down section 12 of the workflow creation apparatus 10 breaks-down animation data to part animation data, however in the case illustrated in Fig. 9A the animation data is output unaltered.

The work content creation apparatus 14 creates work names as described below. First the motion analysis section 20 refers to the motion pattern DB 30 and the motion condition DB 32 of the first storage section 34, and derives a work pattern. The motion analysis section 20 extracts the motion range of "component C". Motion range can be derived from positions of component C (for example the motion start coordinates, the motion end coordinates) contained in the motion data corresponding to the component C in the animation data. In the example of Fig. 9A to Fig. 9C, the motion range of the component C is derived between the motion start position 90 and the motion end position 92. Note that when there are differences in position due to orientation (for example the motion start orientation and the motion end orientation) then orientation may be included. The motion condition and the motion pattern are derived for the motion of the component C in the extracted motion range of the component C. In this example these correspond respectively to D002, D003, D007, D012 of the motion pattern DB 30 and DJ003 of the motion condition DB 32.

The name computation section 26 next refers to the work-motion DB 36 and extracts work name candidates corresponding to the relationship between work pattern and work condition determined by the motion analysis section 20. In this example the relationship here between work pattern and work condition determined by the motion analysis section 20 is DJ003, and so work names of "push in", "insert", "tighten", "adhere" etc. associated with work condition DJ003 are extracted as first work name candidates. The name computation section 26 also extracts text from explanatory information contained in the motion range of "component C". In this example "do not touch terminals" and "peel off release paper" are extracted as text. Then correspondence relationships are determined for text registered in the work-work keyword DB 38 that contain the extracted text, and the work names with the determined correspondence relationships are extracted as work name candidates. In this example, the work name "adhere" of ST029 is extracted as a second work name candidate. The name computation section 26 then determines the work name candidate "adhere" that is a match between the first work name candidates and the second work name candidate as the work name for the work. Note that when text are extracted from explanatory information, since there is variation in the choice of words, in order to resolve the variation in choice of words configuration may be made with plural dictionaries prepared, such a dictionary provided with synonyms, conjugations (particles) and reference made to such a dictionary to in order to convert texts including the variation into the same word phase.

The work operation construction section 28 then refers to the work content DB 44 and derives the work content corresponding to the work name and component name determined by the name computation section 26. In this example the corresponding entry is SN0041, work content of "adhere" is derived, and the work operation construction section 28 connects the component name to determine "adhere component C" as the work content.

The workflow construction section 16 of the workflow creation apparatus 10 constructs workflow data based on the work content derived by the work content creation apparatus 14. First the workflow construction section 16 creates data in which the configuring components contained in the animation data are arranged in work sequence. In the animation data of Fig. 9A, as illustrated in Fig. 9B, data is created in which symbols depicting the components (illustrated by inverted triangular symbols in Fig. 9B, referred to below as component symbols) 96 are depicted together with component names and are connected together in the sequence of appearance in the animation data. Next the workflow construction section 16, as illustrated in Fig. 9C, creates workflow data by inserting symbols representing work (illustrated by white circle symbols in Fig. 9C, referred to below as work symbols) 97 into the data illustrating the work content derived by the work content creation apparatus 14, inserting at the position of the work in the animation data (work operation 98).

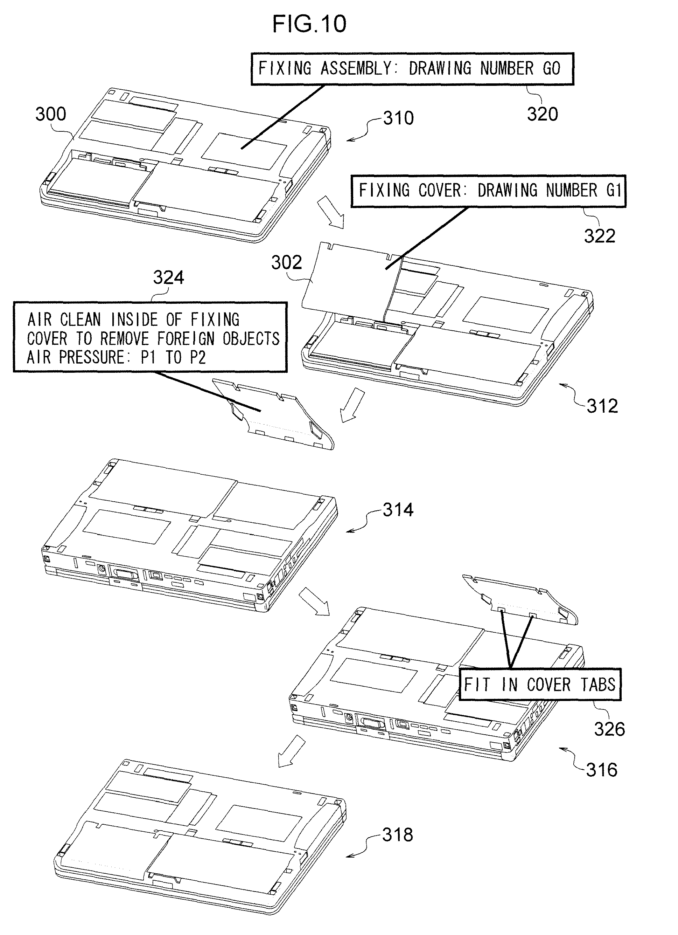

An outline explanation of the workflow creation processing has been given above, however more detailed explanation of workflow creation processing follows with reference to Fig. 10 to Fig. 16.

Fig. 10 is an illustration of animation data. The animation data illustrated in Fig. 10, as work related to assembling a product, illustrates work assembling an assembly component 302 to a main body 300 as the work subject. Namely, Fig. 10 illustrates a process from a state 310 illustrating the main body 300, through a state 312 illustrating the assembly component 302, a state 314 illustrating a first work step, a state 316 illustrating a second work step, to a state 318 in which assembly work has finished and the device is complete. The state 310 illustrates a case in which text "fixing assembly: drawing number G0" is displayed as an explanation or explanatory information for data related to the main body 300. State 312 illustrates a case in which text "fixing cover: drawing number G1" is displayed as an explanation or explanatory information for data related to the assembly component 302. State 314 illustrates a case in which text "air clean inside of fixing cover to remove foreign objects" and "air pressure: P1 to P2" is displayed as an explanation or explanatory information for data related to the assembly component 302. State 316 illustrates a case in which text "fit in cover tabs" is displayed as an explanation or explanatory information for data related to the assembly component 302.

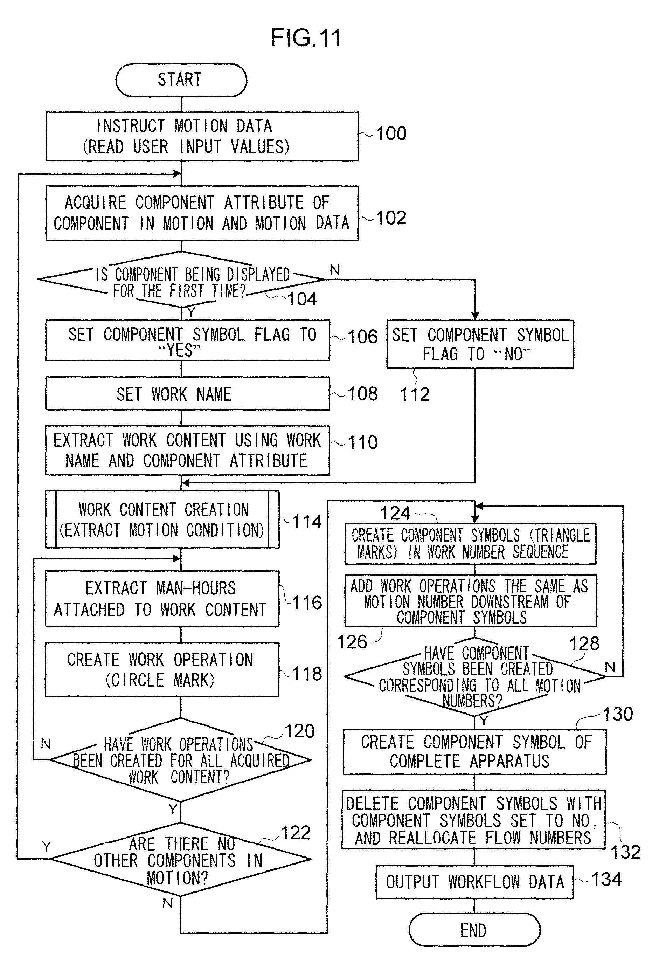

The processing routine illustrated in Fig. 11 is executed in the workflow creation processing, and animation data of the workflow creation subject instructed by an operator is acquired at step 100. The acquired animation data is input to the break-down section 12 of the workflow creation apparatus 10. Then at step 102, the break-down section 12 breaks-down the animation data into part animations. The break-down section 12 acquires the component attributes and motion data for components in motion. Namely, component attributes and motion data are acquired for components in motion. First the motion range is derived, then data contained in the motion range is acquired. Examples of data contained in the motion range include motion start position, motion end position, motion start position orientation, motion end position orientation, initial position, orientation of the initial position. Other examples of data contained in the motion range include component attribute (component name, drawing number), motion subsequent to current motion, motion previous to current motion, component being displayed for the first time, motion number (motion sequence number) and explanation in motion range.

Specifically, at step 102 a single motion from motion start to motion end is calculated as the motion range. The motion start is when a newly displayed component or component being displayed starts to move, the motion end is the position after motion start just prior to another different component motion start or the final position at motion completion. In this example the data acquired is the data of the motion start when a fixing assembly that is the main body 300 is initially displayed, the motion start coordinates and the motion start orientation are acquired from the coordinates when displayed. Then data is acquired for the motion end when after motion has progressed another component (in this example the fixing cover that is the assembly component 302) is displayed, and the motion end coordinates and the motion end orientation are acquired from the coordinates of the fixing assembly when the fixing cover is displayed. An example of the acquired content is illustrated below. Note that motion numbers have been appended in order to be able to distinguish between motions in the following processing. "1" is appended when it is the first motion.

### Acquired Content

### Motion Number: 1

| | | | |
|---|---|---|---|
| Motion Start Coordinates: | X = 1.5 | Y = -123.6 | Z = 190.7 |
| Motion End Coordinates: | X = 1.5 | Y = -123.6 | Z = 190.7 |
| Motion Start Orientation: | X = 0° | Y = 0° | Z = 0° |
| Motion End Orientation: | X = 0° | Y = 0° | Z = 0° |

At step 102 the initial position of the component in motion is extracted. The initial position of the component is expressed by relative coordinates to a component or component group of higher order with respect to the component of the work subject (in this example the assembly on the first stage layer). Note that configuration may be made such that when there is no higher order component or component group, overall coordinates from the component or component group first displayed in the animation data may be employed.

### Initial Position

| | | | |
|---|---|---|---|
| Initial Position: | X = 1.5 | Y=-123.6 | Z = 190.7 |
| Orientation of the initial position: | X = 0° | Y = 0° | Z = 0° |

At step 102 the component attribute of the component in motion is acquired. In this example "component name: fixing assembly" and "drawing number: G1" are acquired. Then checking is performed as to whether or not this component is being displayed for the first time. Namely, a track back from the motion number 1 to the top of the motions is performed to check whether or not this component is already being displayed. Since in this example the fixing assembly was not displayed prior to motion of the motion number 1 confirmation is made that this is a component displayed for the first time.

At step 102, a check is performed as to whether or not this component has a motion other than the current motion. Namely, a check is performed as to whether or not there is another motion of the fixing assembly by tracking back from the motion of the motion number 1 to the top motion, and a check is performed as to whether or not there is another motion of the fixing assembly by moving on from the motion of the motion number 1 to the final motion. In this example confirmation is made that there is no previous motion to the current motion, and there is no subsequent motion to the current motion.

Next at step 104 determination is made as to whether or not this is a component being displayed for the first time, with processing proceeding to step 106 when determination at step 104 is affirmative, and processing proceeding to step 114 when determination at step 104 is negative. In this example, since it has been confirmed at step 102 that the component is being displayed for the first time, determination at step 104 is affirmative, and at step 106 a component symbol flag is set on (component symbol flag: Yes). The component symbol flag is a flag stored with a setting value enable output of the component symbol (the inverted triangular shaped symbol in Fig. 9B, 9C) to workflow data.

At the next step 108, since this is a component being displayed for the first time, the work name is, for example, set to "collect". Namely, a component being displayed for the first time is set for example with "collect" since there is an accompanying motion to move the component for example from a manufacturing line to a work bench. Then at the next step 110, reference is made to the work content DB 44, and work content matching the component name and work name is acquired. In this example the component name is "fixing assembly" and the work name is "collect", and so the number "SN0001" matches. Consequently, "collect fixing assembly" is determined as the work content. Note that configuration may be made such that when there is no corresponding component name then component name "", work name "collect" and work content "collect" are set.

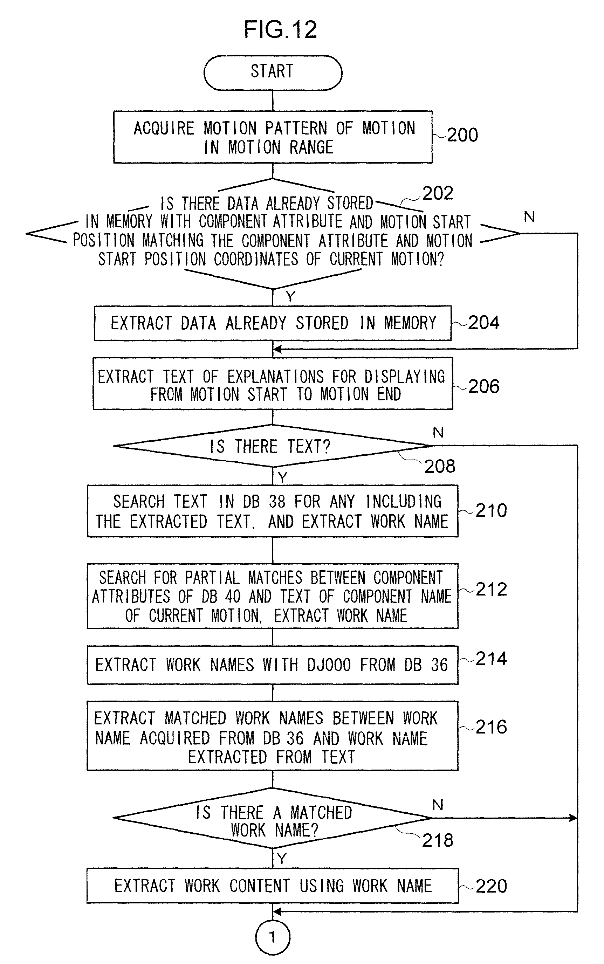

At the next step 114, the work content creation apparatus 14 executes work content creation processing. The work content creation processing (step 114) executed by the work content creation apparatus 14 is execution of the processing illustrated in Fig. 12 to Fig. 16. The work content creation apparatus 14 acquires a work pattern at step 200 illustrated in Fig. 12. Namely, the motion analysis section 20 of the work content creation apparatus 14 acquires a motion condition that matches the motion pattern for the motion in the motion range in the data acquired at step 102 of Fig. 11. Specifically, the content of the motion pattern of the motion pattern DB 30 corresponds to the motion of the motion range of the component, and the number (any of DJ000 to DJ003) that matches the motion condition in the motion condition DB 32 is identified. In this example DJ000 in the motion condition DB 32 corresponds.

The work content creation apparatus 14 checks at step 202 whether or not in the past there has been a component for work with the same motion start position and motion end position by checking whether such data is stored in memory. When there is data already stored in the memory (determination at step 202 is affirmative), then this previously stored data is extracted at step 204 and processing proceeds to step 206. The data extracted at step 204 is data including explanatory information and work content. However processing proceeds straight to step 206 when determination at step 202 is negative. Note that processing of step 204 is a function executed by the animation operation computation section 22 of the name computation section 26.

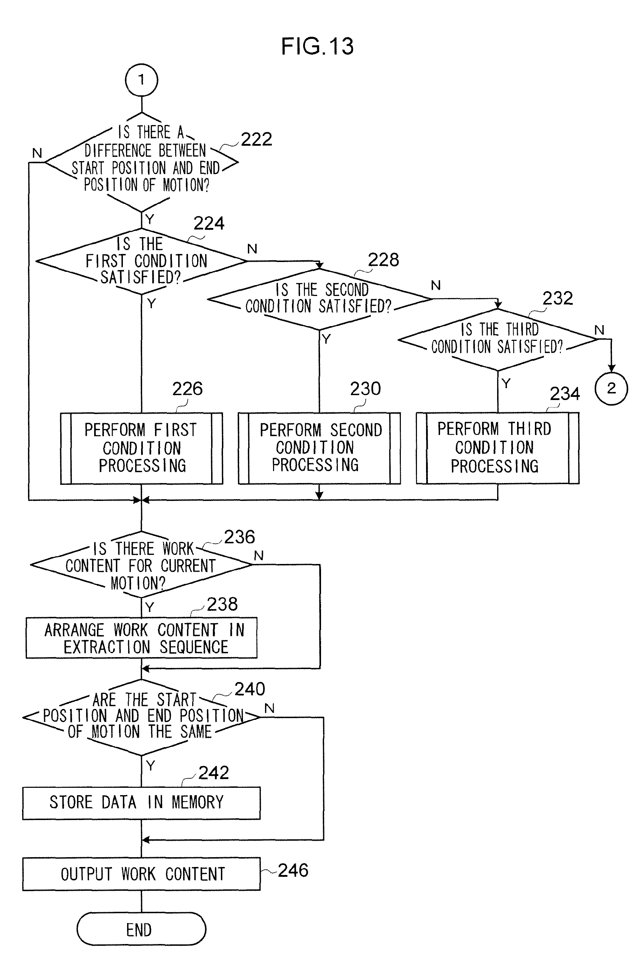

At step 206, the animation operation computation section 22 of the name computation section 26 then extracts all the text of explanations of motion number 1 for display from the motion start to the motion end. In this example the text "fixing assembly: component number G0" is extracted. At step 206 the animation operation computation section 22 determines whether or not text was extracted at step 206, when the detarmination at step 206 is affirmative processing proceeds straight to step 222, skipping processes 210 to 220 (Fig. 13). However, when determination at step 208 is negative, the animation operation computation section 22 makes a search at step 210 for correspondence relationships for data in which the text in the work-work keyword DB 38 are included in the extracted text. The animation operation computation section 22 extracts the work name of correspondence relationships in the search results as work name candidates. Then at step 212, a search is performed for a partial match between component attributes in the work-component DB 40 and text of the component name for the current motion, and extracts any matches as work name candidates. At step 214, the ancillary operation computation section 24 then extracts as candidates for the work name of number "DJ000" of the motion condition from the work-motion DB 36. At step 216, the name computation section 26 then extracts a work name by matching the work name candidate extracted by the animation operation computation section 22 against the work name candidates extracted by the ancillary operation computation section 24. Then at step 218, determination is made as to whether or not there is a work name that has matched in the results of step 216, processing proceeds straight to step 222, skipping step 220, when there is a matched work name. In this example, since there is no matching work name processing proceeds to step 222. However, when there is a work name that matches processing proceeds to step 220. At step 220 the work operation construction section 28 extracts work content corresponding to the work name from the work content DB 44.

At step 222 the work content creation apparatus 14 confirms whether or not there is a difference between the motion start position and the motion end position of the component. In this example the motion start position and the motion end position match and so the determination of step 222 is negative, and at step 236 confirmation is made as to whether or not there is work content for the current motion. Since the work content of "collect fixing assembly" was set at step 108 for the motion number 1, determination at step 236 is affirmative, and the work operation construction section 28 rearranges the work content in the sequence extracted by the processing described above. The current processing is motion number 1 and there is only one item of work content and so processing results in "No. 1: collect fixing assembly".

The work operation construction section 28 then at step 240 checks whether or not the motion start position and the motion end position of the component are the same as each other. The current processing is motion number 1, and since the motion start coordinates and the motion end coordinates match, determination at step 240 is affirmative, and at step 242 the work operation construction section 28 stores the data in the memory. Respective data for component name "fixing assembly", motion start position "X = 1.5 Y = -123.6 Z = 190.7", explanation text "fixing assembly: drawing number G0" and work content "collect fixing assembly" is stored in the memory. Then at step 246 the work operation construction section 28 outputs data of work content to the workflow construction section 16. Note that configuration may be made such that at step 242 the work operation construction section 28 outputs the respective data stored in the memory.

The work operation construction section 28 completes work content creation processing for the motion number 1 by the processing at step 246, and processing proceeds to step 116 of Fig. 11. At step 116, the workflow construction section 16 refers to the work content DB 44 and extracts the man-hours attached to the work content. Note that the processing of step 116 by the workflow construction section 16 may be skipped. Next, at step 118 the workflow construction section 16 generates a work operation. Specifically, the name of the work operation is set for the work content. Note that configuration may be made such that the component attribute and the man-hours are also set. The work operation "collect fixing assembly" is set as the work name for current motion number 1. Moreover, the component name may be set to "fixing assembly", the man-hours may be set to "0.1", the motion number that is the sequential number representing the motion sequence may be set to "1", and the work operation number that is the sequential number representing the work operation sequence may be set to "1".

The workflow construction section 16 then determines at step 120 whether or not a work operation has been generated for all of the acquired work content, and the processing of steps 116 and 118 are repeatedly performed until determination is affirmative. When determination at step 120 is negative, the workflow creation apparatus 10 determines whether or not there are other moving components. Processing returns to step 102 when there are other moving components remaining, and the remaining processing of the motion is performed. However, when there are no other moving components remaining, determination at step 122 is affirmative, and processing proceeds to step 124.

Processing for the motion number 1 is completed as described above and transition is made to processing for the next motion. Namely, at step 102, the break-down section 12 calculates the motion range for motion number 2. The motion of the motion number 2 has a motion start when the fixing cover is displayed, and, since there are no other motions after progression to the next motion when the fixing cover motion has been completed, the motion start coordinates, the motion start orientation, the motion end coordinates and the motion end orientation are acquired when movement of the fixing cover ends. The initial position and orientation of the initial position of the component moving in the motion number 2 is also extracted, and component attributes of the component acquired. In this example data the component name "fixing cover" and drawing number "G1" are acquired.

Since the component of motion number 2 "fixing cover" is a component being displayed for the first time (determination at step 104 is affirmative), the component symbol flag is set on. Then the work name is set to "collect" and data "collect fixing cover" is acquired for work content using the work content DB 44 (steps 106 to 110). In the work content creation apparatus 14, for the component of the motion number 2, there had previously been a component with the same motion start position and motion end position, and this data is stored in memory, however the data stored in the memory and the motion data of the motion number 2 are different. Namely, the component name in the memory is "fixing assembly" and the component name of motion number 2 is "fixing cover" and so determination at step 202 is negative, and all text for explanations to be displayed in the motion number 2 from the motion start to the motion end is extracted (step 206). The text of the extracted explanation is "fixing cover: drawing number G1", "air clean inside of fixing cover to remove foreign objects", "air pressure: P1 to P2", "fit in cover tabs".

Since text has been extracted (determination at step 208 is affirmative), a search is made for text in the work-work keyword DB 38 included in the extracted text, and relevant work name candidates extracted. The text "air clean" contained in the extracted explanation, and the text "air clean" in the ID "ST014" of the work-work keyword DB 38 match. The text "tab" included in the extracted explanation and the "tab" of ST032 in the work-work keyword DB 38 match. The text "fit in" included in the extracted explanation and the text "fit in" of ST031 in the work-work keyword DB 38 also match. Consequently, the work names "air clean" and "fit in" of the work-work keyword DB 38 are set as work name candidates (step 210).

Next, since there is no partial match of the component name (fixing cover) of the motion of the motion number 2 to the component attributes in the work-component DB 40, the work name is left blank (step 212), and the work names with condition name DJ000 in the work-motion DB 36 are extracted as work name candidates (step 214). Since there is a match with the text "air clean" of the work name candidates (determination at step 218 is affirmative), work content is searched for from the work content DB 44 (step 220). Since there is no match to conditions of component name "fixing cover" and work name "air clean" in the work content DB 44, search is re-performed with component name: "", work name "air clean" and there is a match at No. SN0031. The work content "air clean" matched at No. SN0031 is accordingly determined as the work name.

Then, since in the motion of the motion number 2 the motion start position and the motion end position differ from each other (determination at step 222 is affirmative), determination is made at step 224 as to whether or not the first condition (DJ001) is satisfied. When the subject motion satisfies the first condition (determination at step 224 is affirmative), after executing the first condition processing of step 226, processing then proceeds to step 236. The motion of the motion number 2 has a different motion start position to the initial position of the component. The motion end position matches the initial position of the component. The motion start position orientation is different from the orientation of the initial position of the component. Consequently, since the content of the motion condition DJ001 is not satisfied processing transitions to step 228.

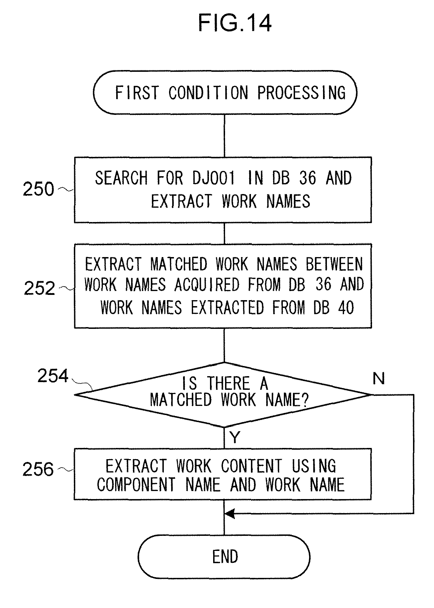

When the subject motion satisfies the first condition (determination at step 224 is affirmative), the first condition processing of step 226 (Fig. 14) is executed.

At step 250 of Fig. 14, work names with the condition name DJ001 representing the first condition are extracted from the work-motion DB 36. At the next step 252, work names are extracted that match between the work names extracted from the work-motion DB 36 and the work names extracted from the work-component DB 40. At the next step 254, determination is made as to whether or not there is a matched work name by determining whether or not a matched work name was extracted at step 252. When there is a matched work name (determination at step 254 is affirmative), work content is extracted from the component name and work name at step 256, thereby completing first condition processing. However, step 256 is skipped when there is no matched work name (determination at step 254 is negative).

When the subject motion has not satisfied the first condition (determination at step 224 is negative), determination is made at step 228 as to whether or not the second condition (DJ002) has been satisfied. When the work of motion number 2 satisfies the second condition (determination at step 228 is affirmative), after the second condition processing has been executed at step 230, processing then proceeds to step 236. In the work of the motion number 2, the motion end position is different from the initial position of the component. The motion end coordinates match the initial position. There is also no motion subsequent to the motion of the motion number 2. Consequently, since the content of the condition name DJ002 are not satisfied, processing transitions to step 232.

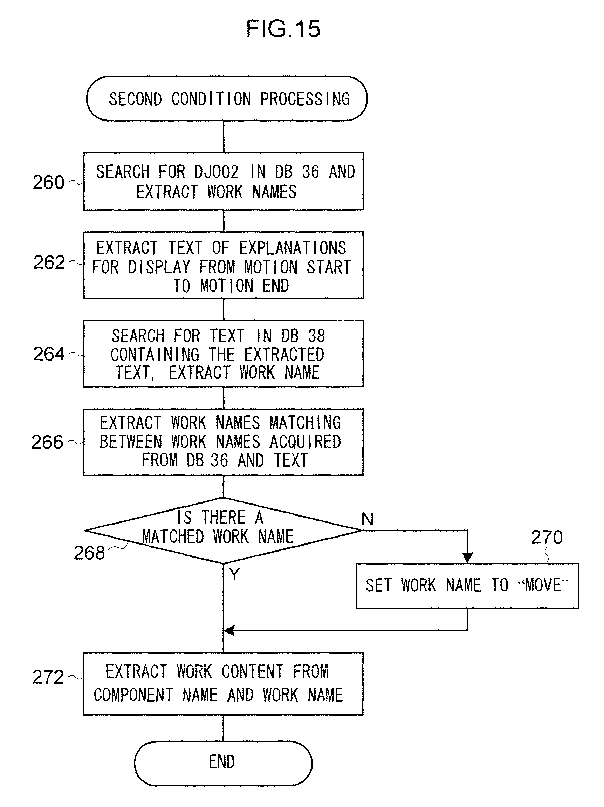

The second condition processing (Fig. 15) is executed at step 230 when the subject motion satisfies the second condition (determination at step 228 is affirmative).

At step 260 of Fig. 15, work names with the condition name DJ002 representing the second condition are extracted from the work-motion DB 36. At the next step 262, all of the explanation text for the subject motion to be displayed from the motion start to motion end is extracted. Then at step 264 a search is made for an ID for text in the work-work keyword DB 38 included in the text that has been extracted at step 262, and the work name of a corresponding ID extracted. Then at step 266, work names are extracted with a match between the work names extracted at step 260 are the work names extracted at step 264. Then at step 268 determination is made as to whether or not there is a matched work name by determining whether or not a matched work name was extracted at step 266. When there is a matched work name (determination at step 268 is affirmative), then at step 272 the work content is extracted from the component name and the work name, thereby completing the second condition processing. However when there is no matched work name (determination at step 268 is negative), the work name is set to "move" at step 270 and processing proceeds to step 272.

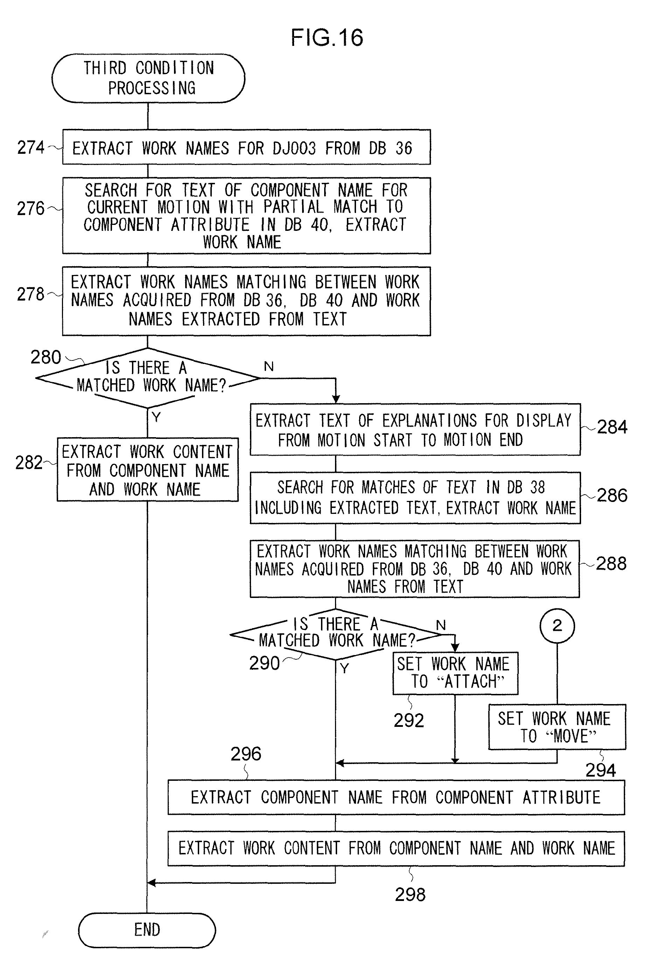

When the motion of the motion number 2 has not satisfied the second condition (determination at step 228 is negative), at step 232 determination is made as to whether or not the third condition (DJ003) has been satisfied. When the motion of the motion number 2 has satisfied the third condition (determination at step 232 is affirmative) then after the third condition processing has been executed at step 234, processing proceeds to step 236. However, when the motion of the motion number 2 has not satisfied the third condition (determination at step 232 is negative), transition is made to step 294 of Fig. 16. In the motion of the motion number 2 the motion start position is different from the initial position of the component. The motion end position matches the initial position of the component. The motion end position orientation matches the orientation of the initial position of the component. There is also no subsequent motion to the current motion. Consequently, the content of the condition name DJ003 is satisfied.

When the subject motion has satisfied the third condition (determination at step 232 is affirmative), the animation operation computation section 22 executes the third condition processing (Fig. 16) at step 234.

At step 274 of Fig. 16, work names with the condition name DJ003 representing the third condition are extracted from the work-motion DB 36. For the motion of the motion number 2, work names: press in, insert, tighten, crimp, adhere, fit in, attach and move are extracted. Next at step 276, work names are extracted from the work-component DB 40. Namely, work names associated with the component attribute in the work-component DB 40 corresponding to the component name of the subject motion are extracted. For the motion of the motion number 2, the component name is "fixing cover", and there is no match to data of component attributes in the work-component DB 40. The work name is accordingly left blank (""). Then at step 278 work names are extracted that match between the work names extracted at step 274 and the work names extracted at step 276, and processing then proceeds to step 280.

At step 280, determination is made as to whether or not there is a matched work name by determining whether or not a matched work name was extracted at step 278. When there is a matched work name (determination at step 280 is affirmative), work content is extracted from the component name and the work name at step 282, thereby completing the third condition processing. However, when there is no matched work name (determination at step 280 is negative), processing proceeds to step 284. There is no matched work name in the motion of the motion number 2 and so processing proceeds to step 284.

At step 284, all text is extracted for explanations to be displayed in the subject motion from the motion start to the motion end. For the motion of the motion number 2 the text: "fixing cover: drawing number G1", "air clean inside of fixing cover to remove foreign objects", "air pressure: P1 to P2" and "fit in cover tabs" is extracted. At the next step 286 a search is made for an ID including text in the work-work keyword DB 38 with the text extracted at step 284, and work names of corresponding ID are extracted. For the motion of the motion number 2 the work name "air clean" of the ID ST014, and the work name "fit in" of the ID ST031 and ST032 are extracted. Note that preferably when there is duplication the duplication is eliminated. Next at step 288, work names are extracted with a match between the work names extracted at step 274 and the work names extracted at 286. For the motion of the motion number 2 the work name "fit in" is extracted.

At the next step 290 determination is made as to whether or not a matched work name was extracted at step 288, with processing proceeding to step 296 when determination at step 290 is affirmative. However, determination at step 290 is negative when there was no matched work name extracted at step 288, the work name is then determined as "attach" at step 292 and processing proceeds to step 296. Note that the work name is set to "move" at step 294 and processing proceeds to step 296. For the motion of the motion number 2, determination at step 290 is affirmative, and processing proceeds to step 296.

At step 296 the component name is extracted from the component attribute for the component of the subject motion. At the next step 298 work content is extracted from the work content DB 44 corresponding to the component name extracted at step 296, thereby completing the third condition processing. For the motion of the motion number 2 the component name is "fixing cover" and the work name is "fit in", and so the work content "fit in fixing cover" at No. SN0005 in the work content DB 44 is extracted.

When one or other of the first condition processing to the third condition processing has been completed, at step 236 (Fig. 13), determination is made as to whether or not work content for the current subject motion has been set. The processing of step 238 is skipped when determination at step 236 is negative. However when determination at step 236 is affirmative, the work operation construction section 28 arranges the work content in the sequence extracted at step 238, and processing transitions to step 240. For the motion of the motion number 2, since there is work content for the motion of the motion number 2 (determination at step 236 is affirmative), the work content is arranged at step 238.

For the motion of motion number 2, the work content "collect fixing cover", "air clean", "fit in fixing cover" are extracted. These work content are arranged in sequence of explanation.
No. 1 work content: collect fixing cover
No. 2 work content: air clean
No. 3 work content: fit in fixing cover

When there is a match between the motion start position and the motion end position for the subject motion number, the work operation construction section 28 stores the data in the memory (step 240, step 242). The motion of the motion number 2 is non-matching.

When the work content creation processing is completed, the workflow construction section 16 refers to the work content DB 44, extracts the man-hours attached to the work content, and creates the work operation (step 116 and step 118 in Fig. 11). In this example the work operation name is "collect fixing cover", component name is "fixing cover", man-hours is "0.1", motion number is "2" and work operation number is "1 ". Next the workflow construction section 16 repeats processing of step 116 to step 118 until all the work operations have been generated for the acquired work content. Thereby, for the motion of the motion number 2, data for the work operation name "air clean", component name "", man-hours "0.8", motion number "2" and work operation number "2" are acquired. Then data for work operation name "fit in fixing cover", component name "fixing cover", man-hours "0.1", motion number "2", work operation number "3" are acquired.

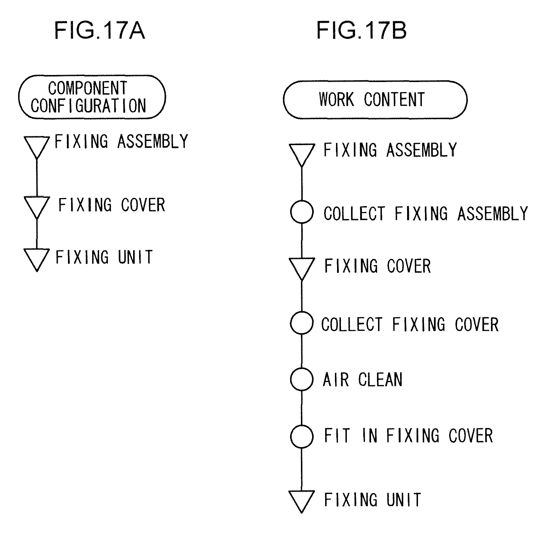

Then at step 124 the component symbols are created in motion number sequence by the workflow construction section 16 of the workflow creation apparatus 10, and at step 126 a work operation the same as the motion number is added downstream of the component symbol. For example, a component symbol for a work operation 1 is added to the sequence numbers of the work operation numbers downstream of the motion number 1. The processing of step 124 and step 126 is repeated until component symbols have been generated corresponding to all of the corresponding motion numbers (until determination at step 128 is affirmative). When component symbols have been generated corresponding to all motion numbers, then at step 130 a component symbol is added for the complete apparatus, and component name extracted using the component attribute of the overall apparatus. Then, since items with component symbol flags of NO are unnecessary in a workflow, these component symbols are deleted, renumbering is performed, and then the workflow data is output at step 134. Fig. 17A and Fig. 17B are images of workflow data output results.

### Second Exemplary Embodiment

Explanation follows regarding a second exemplary embodiment. The present exemplary embodiment is configured substantially the same as the above exemplary embodiment, therefore the same reference numerals are allocated to similar portions and further detailed explanation is omitted. The present exemplary embodiment creates a workflow by employing animation data in which another component starts moving while a given component that moves is still in motion.

Explanation follows regarding operation of the present exemplary embodiment.

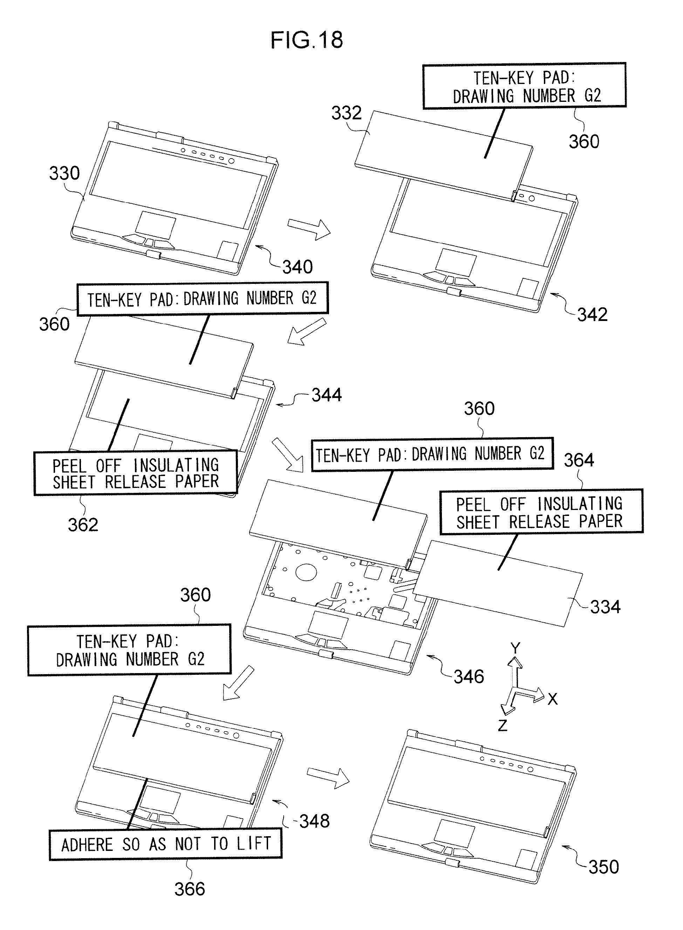

Explanation first follows regarding animation data according to the present exemplary embodiment, with reference to Fig. 18. In the present exemplary embodiment, as work related to component assembly, animation data expresses a work subject of work to assemble an assembly component 332 to a main body 330. Namely, Fig. 18 illustrates a process from a state 340 to state 350. State 340 illustrates a state in which the main body 330 is displayed, and state 342 illustrates a state in which the assembly component 332 is displayed. The state 344 illustrates a state in which a first explanation is displayed, state 346 illustrates a state with accompanying motion of another component, state 348 illustrates a state in which a second explanation is displayed, and state 350 illustrates a state in which assembly work has finished and the apparatus is complete. In state 340, as data related to the main body 330, text of "fixing assembly: drawing number Gx" is included as explanation or explanatory information. State 342 illustrates a case in which, as data related to the assembly component 332, text of "ten-key pad: drawing number G2" is displayed as explanation or explanatory information. State 344 illustrates a case in which text of "peel off insulating sheet" as a work instruction is displayed as explanation or explanatory information. State 346 illustrates a case in which, as data for assisting work of the other component 334, text of "peel off insulating sheet" of the assembly component 302 is displayed as explanation or explanatory information. State 348 illustrates a case in which text of "adhere so as not to lift up" for assisting work of the assembly component 302 is displayed as explanation or explanatory information data.

In the workflow creation processing of the present exemplary embodiment, animation data for the workflow creation subject instructed by an operator is acquired, and the animation data is broken down into part animations in the break-down section 12 of the workflow creation apparatus 10 (step 100, step 102). More specifically, a single motion from motion start to motion end is calculated as the motion range. The motion start is taken as when a fixing assembly that is the main body 330 is displayed for the first time, and the motion start coordinates and data of the motion start orientation are acquired from the coordinates when displayed. The motion end is taken as when, after motion has progressed, another component (in this example the ten-key pad that is the assembly component 332) is displayed, and the motion end coordinates and data for the motion end orientation are acquired from the coordinates of the fixing assembly when the ten-key pad is displayed. The motion number "1" is appended since it is the first motion.

The initial position of the component in motion is extracted, and the component attribute of the component acquired (in this example "component name: fixing assembly", "drawing number: Gx") and since it is a component being displayed for the first time the component symbol flag is set on (step 104, step 106). Then the work name is set to "collect", and with reference to the work content DB 44, the work content matching the component name and the work name is acquired (step 108, step 110). In this example the component name is "fixing assembly" and the work name is "collect" and so the number "SN0001" matches, and the work content is determined as "collect fixing assembly".

Then the work content creation apparatus 14 executes the work content creation processing as described above (step 114). The work operation construction section 28 creates data with work number 1 and work operation number 1 of work content "collect fixing assembly" and outputs the data for work content to the workflow construction section 16. The processing for the motion number 1 is thereby complete, transition is made to processing for the next motion, namely to processing of the motion number 2.

In the processing of motion number 2, first the motion range, initial position and orientation of the initial position are extracted, and since the component name as a component attribute of the component is "ten-key pad", the data of drawing number "G2" is acquired. The subject component "ten-key pad" is a component being displayed for the first time, and so the component symbol flag is set on, the work name is set to "collect" and the data "collect ten-key pad" of the work content in the work content DB 44 is acquired (step 102 to step 110). Then the work content creation processing as described above is executed (step 114). The work operation construction section 28 creates data with work number 2, work operation number 1, and work content "collect ten-key pad", and outputs data of the work content to the workflow construction section 16. When the processing on motion number 2 has been completed, transition is made to the processing for the next motion, namely to the processing of motion number 3.

In the processing of motion number 3, the motion range, initial position, orientation of the initial position, and component attribute are extracted. Specifically, motion start is taken as when the insulating sheet starts to move out, and data is acquired for the motion start coordinates and the motion start orientation from the coordinates when the insulating sheet starts moving out. Then as motion progresses, motion end is taken as when another component (the ten-key pad in this example) starts in motion, and data is acquired for the motion end coordinates and the movement end orientation from the coordinates of the insulating sheet when the ten-key pad starts in motion. Since this is the first motion, the motion number "3" is appended. The component attribute is acquired for the data with component name "insulating sheet". Note that when data of drawing number "G3" is appended, the data for the drawing number is also acquired. Since the subject component of the "insulating sheet" is not a component being displayed for the first time, the component symbol flag is set off (step 112) and the work content creation processing is executed (step 114).

In the work content creation apparatus 14, the data of the component of the motion number 3 and the data stored in memory is compared. The component name of the motion number 3 is "insulating sheet", and since this is different from the data of component names "fixing assembly" and "ten-key pad" stored in the memory, all text for explanations to be displayed in the motion number 3 from the motion start to the motion end are extracted (step 202 to step 206). Then a search is performed for entries with text of the work-work keyword DB 38 included in the extracted text, and these entries extracted as work name candidates. The text "release paper" included in the extracted explanation and the text "release paper" of ID "ST029" in the work-work keyword DB 38 match. Therefore the work name "adhere" of the ID "ST029" in the work-work keyword DB 38 is set as a work name candidate (step 208, step 210).

Next a search is performed for a partial match between text of component attributes in the work-component DB 40 and the component name (insulating sheet) for the motion of the motion number 3. In this example there is a match between component name (insulating sheet) of the motion of the motion number 3 and the text "sheet" included in the component attribute of ID "SA016" of the work-component DB 40. The "peel off' of ID "SA016" is accordingly extracted (step 212). Then out of the work names with the condition name DJ000 in the work-motion DB 36 that have been extracted as work name candidates, a search is made for the work name "peel off' extracted from the work-component DB 40. Since there is no corresponding entry the work name is left black (step 214, 216) and processing proceeds to step 222.

Then, since there is a difference between the motion start position and motion end position in the motion of the motion number 3 (determination at step 222 is affirmative), determination is made that the first condition (DJ001) has been satisfied (step 224). The motion of the subject motion number 3 satisfies the first condition (step 224). Namely, the motion start position match, the motion end position differ, and the orientation of the initial position match. The first condition processing is accordingly executed and the work content extracted (step 226).

When the subject motion satisfies the first condition (determination at step 224 is affirmative), the first condition processing (Fig. 14) of step 226 is executed.

The work name for the condition name DJ001 expressing the first condition are extracted from the work-motion DB 36, and work names are extracted that match from between the work names extracted from the work-motion DB 36 and the work names extracted from the work-component DB 40 (step 250, step 252). In the subject motion, the component name (insulating sheet) of the motion of the motion number 3 and the text (sheet) included in the component attribute of the ID "SA016" of the work-component DB 40 match, and so the work name "peel off" of the ID "SA016" is extracted. Then, from among the extracted work name candidates of work names with condition name DJ001 in the work-motion DB 36, since the work name "peel off' extracted from the work-component DB 40 corresponds to the work name of the condition name J013, the work name is taken as "peel off'. Then since there is a matched work name (determination at step 254 is affirmative), work content is extracted from component name and the work name using the work content DB 44 (step 256), thereby completing the first condition processing. In the subject motion, the No. SN0034 in the work content DB 44 matches and so "peel off' of the No. SN0034 is extracted as work content.

Then, since for the current subject motion the work content is set, the work operation construction section 28 then arranges the work content in the extracted sequence, and outputs the work content (step 236 to 246). When work content creation processing has been completed, the workflow construction section 16 extracts the man-hours attached to the work content with reference to the work content DB 44, and creates the work operation (step 116, step 118). The current subject motion has a work operation name that is the work name "peel off", component name "insulating sheet", man-hours "0.3", motion number "3", and work operation number "1".

Then since the work operation has been generated for all the acquired work content and there is no other motion component (determination at step 120 is Y, determination at step 122 is Y), the workflow construction section 16 completes the processing for the motion number 3, and transitions to processing for the next motion, namely the processing for the motion number 4.

Then in the processing for the motion number 4, the motion range is calculated in the break-down section 12. Namely, the motion start coordinates, the motion start orientation, the motion end coordinates and the motion end orientation are acquired, and the initial position and orientation of the initial position are extracted, and the component attribute acquired (step 102). In this example the component name is "ten-key pad" and data for drawing number "G2" is acquired.

The component of the motion number 4 "ten-key pad" is not a component being displayed for the first time and so the component symbol flag is set off (step 112), and the work content creation apparatus 14 transitions to the work content creation processing by (step 114). In the work content creation apparatus 14, for the component of the motion number 4, in the past there has been another case with the same motion start position and motion end position and this data is stored in memory. The work content creation apparatus 14 accordingly confirms the match between the data stored in the memory and the motion data of the motion number 4. Namely, the component name "ten-key pad" has been previously stored in the memory, and since the component name of the motion number 4 is "ten-key pad", all the text of explanations to be displayed in the motion number 4 from the motion start to the motion end are extracted (step 206). The extracted explanation text is "ten-key pad: drawing number G2" and "adhere so as not to lift up".

The text "release paper" included in the extracted explanation and the text "release paper" in the ID "ST029" of the work-work keyword DB 38 match. The work name "adhere" of the ID "ST029" of the work-work keyword DB 38 is accordingly set as the work name candidate (step 208, step 210).

A search is next made for a partial match of the component name (ten-key pad) of the motion of the motion number 4 in the text of the component attributes of the work-component DB 40. In this example there is no text included in the component attributes of the work-component DB 40 with a partial match to the component name (ten-key pad) of the motion of the motion number 4. Therefore the work name is left blank (step 212). Then, in the work names with the condition name DJ000 in the work-motion DB 36 extracted as work name candidates, a search is performed for the work name "" extracted from the work-component DB 40. Since there is no corresponding entry found, the work name is left blank (step 214, step 216).

Then, comparison of the motion start position and the motion end position in the motion of the motion number 4 represents a difference (determination at step 222 is affirmative), and so determination is made as to whether or not the first condition (DJ001) is satisfied (determination at step 224 is affirmative). The motion start position in the motion of the motion number 4 and the initial position of the component differ, the motion end position matches the component initial position, and the motion start position orientation matches the orientation of the initial position of the component. Hence, since the motion of the subject motion number 4 does not satisfy the first condition (determination at step 224 is negative), determination is made as to whether or not the second condition (DJ002) is satisfied (step 228). The motion end position of the motion of the motion number 4 matches the component initial position. There is no motion subsequent to the motion number 2. Consequently, since the content of the motion condition name DJ002 is not satisfied, determination is made as to whether or not the third condition (DJ003) is satisfied (step 232). The motion start position in the motion of the motion number 4 is different from the component initial position. The motion end position matches the component initial position. The motion end position orientation matches the orientation of the initial position of the component. There is no motion subsequent to the current motion. Consequently, the content of the motion condition name DJ003 is satisfied.

The third condition processing is executed by the animation operation computation section 22 (step 234). First, the work names with the condition name DJ003 expressing the third condition are extracted from the work-motion DB 36. For the motion of the motion number 4, similarly to the motion number 2, the work names: press in, insert, etc. are extracted, and the work name is extracted from the work-component DB 40 (step 274, step 276). In the motion of the motion number 4, the component name is "ten-key pad", and there is no match to data of component attributes in the work-component DB 40. The work name is accordingly left blank. Then since for the motion of the motion number 4 there is no work name in the work names extracted from the work-motion DB 36 (determination at step 280 is negative), all of the text are extracted for explanations to be displayed in the subject motion from the motion start to the motion end. The motion of the motion number 4 has text: "ten-key pad: drawing number G2" and "adhere so as not to lift up". Next a search is performed for an ID with text in the work-work keyword DB 38 that includes the text extracted at step 284, and work names of corresponding IDs extracted (step 286). In the motion of the motion number 4 the work name "adhere" from the ID ST029 is extracted. Then work names are extracted that match between the work names extracted at step 274 and the work names extracted at step 286 is extracted (step 288). In the motion of the motion number 4 the work name "adhere" is extracted.

Then determination is made as to whether or not a matched work name was extracted at step 288 (step 290). In the motion of the motion number 4, there is a matched work name, and so at step 296 the component name is extracted from the component attribute for the component of the subject motion. Then at step 298, the work content corresponding to the component name extracted at step 296 is extracted from the work content DB 44, thereby completing the third condition processing (step 296, step 298). In the motion of the motion number 4 the component name is "ten-key pad" and the work name is "adhere", and so the work content for the No. SN0008 in the work content DB 44 of "adhere ten-key pad" is extracted.

As described above, when the work content for the motion of the motion number 4 has been extracted and the work content is set for the current subject motion, and the work operation construction section 28 arranges the work content in the sequence the explanations were extracted (step 238). Work content "adhere ten-key pad" is extracted for the motion of the motion number 4. The work operation construction section 28 then stores data in memory when the motion start position and the motion end position of the subject motion number match (step 240, step 242). There is no match for the motion of the motion number 4.

When the work content creation processing has been completed, the workflow construction section 16 refers to the work content DB 44, and extracts the man-hours attached to the work content to generate the work operation (step 116, step 118). In this example the work operation name is "adhere ten-key pad", the component name is "ten-key pad", the man-hours is "0.5", the work number is "4" and the work operation number is "1". The workflow construction section 16 then determines whether or not work operations have been generated for all the acquired work content and whether or not there are no other motion components (step 120, step 122). In this example work operations have been generated for all work content and there are no other components that move, and so both determinations are affirmative.

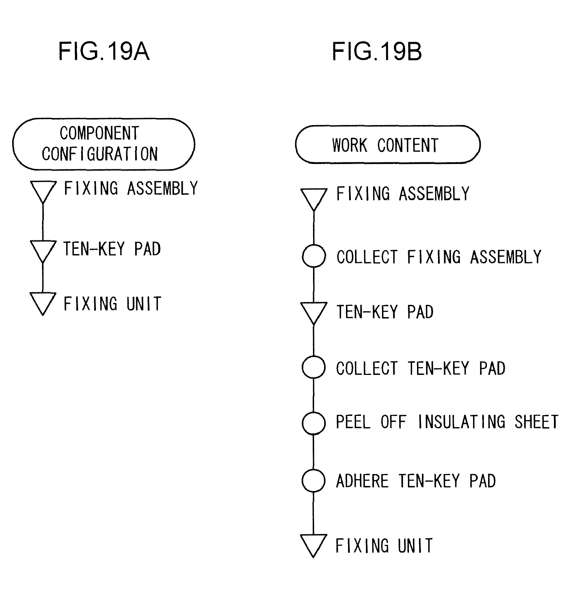

Then the workflow creation apparatus 10 employs the workflow construction section 16 to generate component symbols corresponding to all motion numbers in motion number sequence, and adds component symbols for work operations with the same work number downstream of the component symbols (step 124 to step 128). When component symbols have been generated corresponding to all the motion numbers, a component symbol is added for the complete apparatus (step 130), and a component name extracted using the component attribute of the overall apparatus. Then, since items with component symbol flags of NO are unnecessary in a workflow, these component symbols are deleted, renumbering is performed, and then the workflow data is output (step 134). Fig. 19A and Fig. 19B is images of workflow data output results.

An exemplary embodiment exhibits the advantageous effect of enabling work content to be determined without relying on experience or skill.

Note that explanation has been given above of an example in which the workflow creation apparatus is implemented by a computer. However, there is no limitation thereto, and obviously various improvements and modifications may be implemented within a range not departing from the spirit explained above.

Moreover, although explanation has been given of embodiments in which programs are pre-stored (installed) in storage sections, there is no limitation thereto. For example, it is possible to provide the workflow creation program and/or the work content creation program of the technology disclosed herein in a format stored on a storage medium, such as a CD-ROM or DVD-ROM.

All cited documents, patent applications and technical standards mentioned in the present specification are incorporated by reference in the present specification to the same extent as if the individual cited documents, patent applications and technical standards were specifically and individually incorporated by reference in the present specification.

## Claims

1. A work content creation apparatus (14) comprising:
a first storage section (34) that stores a motion pattern expressing a category of motion of a component and a motion condition expressing a condition to classify motion of the component;
a second storage section (42) that stores a correspondence relationship between a work name expressing a name of work performed on the component and the motion condition relationship to motion pattern of the component;
a third storage section (46) that stores a correspondence relationship between the work name, a component name that is a term for the component, and work content expressing content of work performed on the component;
a motion analysis section (20) that derives a motion range for a component that moves from animation data representing movement in 3-dimensional space of a component with a component name for work subject to processing, and based on the motion pattern and the motion condition stored in the first storage section (34), derives the motion condition relationship to motion pattern of the component in the motion range;
a name computation section (26) that, based on the correspondence relationship stored in the second storage section (42), derives a work name corresponding to the motion condition relationship to motion pattern derived by the motion analysis section (20); and
a work operation construction section (28) that, based on the correspondence relationship stored in the third storage section (46), derives work content corresponding to the work name derived by the name computation section (26) and the component name as work content of work performed on the component.

2. The work content creation apparatus (14) of claim 1, wherein
the animation data contains motion data including the position of the component of the work subject to processing, and
the motion analysis section (20) derives the motion condition relationship to motion pattern based on the position of the component contained in the motion data of the animation data.

3. The work content creation apparatus (14) of claim 1 or claim 2, wherein
the animation data contains a component attribute including the component name associated with the component,
the second storage section (42) stores a correspondence relationship between the component attribute including component name associated with the component and the work name, and
the name computation section (26) derives the work name based on the motion condition relationship to motion pattern derived by the motion analysis section (20) and based on the component name contained in the component attribute of the animation data.

4. The work content creation apparatus (14) of any one of claim 1 to claim 3, wherein
the animation data includes explanatory information expressing content to assist work performed on the component;
the second storage section (42) stores a correspondence relationship between content to assist work performed on the component and work name; and
the name computation section (26) derives a work name based on the motion condition relationship to motion pattern derived by the motion analysis section (20) and based on the content to assist work performed on the component included in the explanatory information of the animation data.

5. The work content creation apparatus (14) of any one of claim 1 to claim 3, wherein
the animation data includes a component attribute containing the component name associated with the component; and
the name computation section (26) employs the component name contained in the component attribute of the animation data as the component name.

6. The work content creation apparatus (14) of any one of claim 1 to claim 5, wherein
the name computation section (26) includes an animation operation computation section (22) that derives a first work name candidate based on the motion condition relationship to motion pattern derived by the motion analysis section and derives a second work name candidate based on the component name included in the component attribute of the animation data, and
the name computation section (26) derives a work name from the first work name candidate and the second work name candidate derived by the animation operation computation section (22).

7. The work content creation apparatus (14) of any one of claim 1 to claim 5, wherein
the name computation section (26) includes:
an animation operation computation section (22) that derives a first work name candidate based on the motion condition relationship to motion pattern derived by the motion analysis section (20); and
an ancillary operation computation section (24) that derives a second work name candidate based on explanatory information that expresses content to assist work performed on the component included in the animation data, and
the name computation section (26) derives a work name from the first work name candidate derived by the animation operation computation section (22) and the second work name candidate derived by the ancillary operation computation section (24).

8. A workflow creation apparatus (10) comprising:
a break-down section (12) that breaks down input animation data representing movement in 3-dimensional space of a product to part animation data representing movement in 3-dimensional space of a component contained in the product, and outputs the broken down part animation data as animation data representing movement in 3-dimensional space of a component with a name;
a work content creation section including a work content creation apparatus (14); and
a workflow creation section (16) that, based on work content created by the work content creation section (14), creates a workflow in which the work content is arranged in work sequence, wherein
the work content creation apparatus (14) includes:
a first storage section (34) that stores a motion pattern expressing a category of motion of the component and a motion condition expressing a condition to classify motion of the component;
a second storage section (42) that stores a correspondence relationship between a work name expressing a name of work performed on the component and the motion condition relationship to motion pattern of the component;
a third storage section (46) that stores a correspondence relationship between the work name, a component name that is a term for the component, and work content expressing content of work performed on the component;
a motion analysis section (20) that derives a motion range for a component that moves from the animation data representing movement in 3-dimensional space of a component with a component name for work subject to processing, and based on the motion pattern and the motion condition stored in the first storage section (34), derives the motion condition relationship to motion pattern of the component in the motion range;
a name computation section (26) that, based on the correspondence relationship stored in the second storage section (42), derives a work name corresponding to the motion condition relationship to motion pattern derived by the motion analysis section (20); and
a work operation construction section (28) that, based on the correspondence relationship stored in the third storage section (46), derives the work content corresponding to the work name and component name derived by the name computation section (26) as work content of work performed on the component.

9. A work content creation method comprising:
(a) deriving a motion range for a component that moves from animation data representing movement in 3-dimensional space of a component with a component name for work subject to processing, and based on a motion pattern expressing a category of motion of the component stored in a first storage section (34) and a motion condition expressing a condition to classify motion of the component, deriving a motion condition relationship to motion pattern of the component in the motion range;
(b) based on a correspondence relationship stored in a second storage section (42) between a motion pattern of the component and a work name expressing a name of work performed on the component, deriving a work name corresponding to the derived motion condition relationship to motion pattern of the component; and
(c) based on a correspondence relationship stored in the third storage section (46) between the work name, a component name that is a term for the component, and work content expressing content of work performed on the component, deriving work content corresponding to the derived work name and the component name as work content of work performed on the component.

10. A workflow creation method comprising:
(a) breaking down input animation data representing movement in 3-dimensional space of a product to part animation data representing movement in 3-dimensional space of a component contained in the product, and outputting the broken down part animation data as animation data representing movement in 3-dimensional space of a component with a name;
(b) deriving a motion range for the component that moves from the animation data representing movement in 3-dimensional space of a component with a component name for work subject to processing, and based on a motion pattern expressing a category of motion of the component stored in a first storage section (34) and a motion condition expressing a condition to classify motion of the component, deriving a motion condition relationship to motion pattern of the component in the motion range;
(c) deriving a work name corresponding to the derived motion condition relationship to motion pattern of the component based on a correspondence relationship stored in a second storage section (42) between a motion pattern of the component and a work name expressing a name of work performed on the component;
(d) deriving work content corresponding to the derived work name and the component name as work content of work performed on the component based on a correspondence relationship stored in a third storage section (46) between the work name, a component name that is a term for the component, and work content expressing content of work performed on the component; and
(e) based on the created work content, creating a workflow in which the work content is arranged in work sequence.

11. A program for causing a computer (80) to execute a work content creation process, the work content creation process comprising:
(a) deriving a motion range for a component that moves from animation data representing movement in 3-dimensional space of a component with a component name for work subject to processing, and based on a motion pattern expressing a category of motion of the component stored in a first storage section (34) and a motion condition expressing a condition to classify motion of the component, deriving a motion condition relationship to motion pattern of the component in the motion range;
(b) based on a correspondence relationship stored in a second storage section (42) between a motion pattern of the component and a work name expressing a name of work performed on the component, deriving a work name corresponding to the derived motion condition relationship to motion pattern of the component; and
(c) based on a correspondence relationship stored in the third storage section (46) between the work name, a component name that is a term for the component, and work content expressing content of work performed on the component, deriving work content corresponding to the derived work name and the component name as work content of work performed on the component.

12. A program for causing a computer (80) to execute a workflow creation process, the workflow creation process comprising:
(a) breaking down input animation data representing movement in 3-dimensional space of a product to part animation data representing movement in 3-dimensional space of a component contained in the product, and outputting the broken down part animation data as animation data representing movement in 3-dimensional space of a component with a name;
(b) deriving a motion range for the component that moves from the animation data representing movement in 3-dimensional space of a component with a component name for work subject to processing, and based on a motion pattern expressing a category of motion of the component stored in a first storage section (34) and a motion condition expressing a condition to classify motion of the component, deriving a motion condition relationship to motion pattern of the component in the motion range;
(c) deriving a work name corresponding to the derived motion condition relationship to motion pattern of the component based on a correspondence relationship stored in a second storage section (42) between a motion pattern of the component and a work name expressing a name of work performed on the component;
(d) deriving work content corresponding to the derived work name and the component name as work content of work performed on the component based on a correspondence relationship stored in a third storage section (46) between the work name, a component name that is a term for the component, and work content expressing content of work performed on the component; and
(e) based on the created work content, creating a workflow in which the work content is arranged in work sequence.
